(19) Europäisches Patentamt
European Patent Office
Office européen des brevets

(11) **EP 4 629 025 A1**

(12) **EUROPEAN PATENT APPLICATION**

(43) Date of publication:
**08.10.2025 Bulletin 2025/41**

(21) Application number: **25162626.3**

(22) Date of filing: **10.03.2025**

(51) International Patent Classification (IPC):
***G06F 1/26*** *(2006.01)* ***G06F 3/06*** *(2006.01)*
***G11C 5/14*** *(2006.01)* ***G11C 16/30*** *(2006.01)*

(52) Cooperative Patent Classification (CPC):
**G11C 16/30; G06F 1/266; G06F 3/0625; G06F 3/0659; G06F 3/0679; G11C 5/147; G11C 5/148**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **03.04.2024 KR 20240045572**
**14.06.2024 KR 20240077758**

(71) Applicant: **Samsung Electronics Co., Ltd.**
**Suwon-si, Gyeonggi-do 16677 (KR)**

(72) Inventors:
- **CHOE, Gyuseok**
  **16677 Suwon-si (KR)**
- **SEO, Sungho**
  **16677 Suwon-si (KR)**
- **SHIN, Myungsub**
  **16677 Suwon-si (KR)**
- **KIM, Jeongsu**
  **16677 Suwon-si (KR)**

(74) Representative: **Marks & Clerk LLP**
**15 Fetter Lane**
**London EC4A 1BW (GB)**

(54) **STORAGE SYSTEM AND METHOD OF OPERATING THE SAME**

(57) There is provided a method of operating a storage system including a host and a device, the method including generating, by the device, a regulated voltage based on a first voltage provided from the host and using the regulated voltage as a driving voltage for driving a device controller of the device, obtaining, by the host, driving voltage information of the device from the device, generating, by the host, a second voltage, based on the driving voltage information, and providing the generated second voltage to the device, and switching, by the device, the driving voltage to the second voltage.

FIG. 2

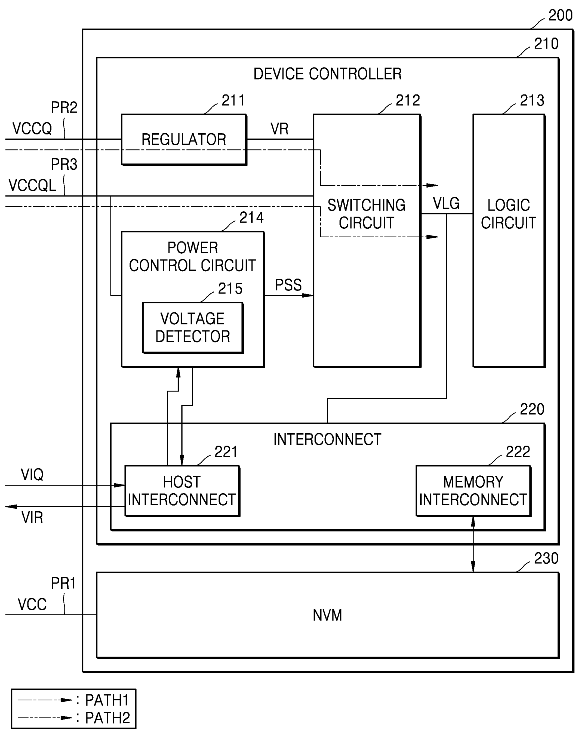


EP 4 629 025 A1

## Description

BACKGROUND

The inventive concepts relate to storage systems, and more particularly, to storage systems and operating methods thereof for improving the efficiency of power supplied to a storage controller.

Semiconductor memory is widely used to store data in various electronic devices, such as computers and wireless communication devices. Nonvolatile memory, a type of semiconductor memory, is a device that may store data even in an environment where power is not supplied to the device. Various mobile devices or electronic devices, such as smartphones, desktop computers, laptop computers, tablet personal computers (PCs), and wearable devices are widely used. These electronic devices include storage devices for storing data. Some storage devices used in mobile devices, portable devices, automotive electronics, or embedded systems may be referred to as universal flash storage (UFS) devices.

SUMMARY

The inventive concepts provide storage systems and operating methods thereof having improved power efficiency, whereby a storage device informs a host of the voltage required or desired by the storage device through communication, and a storage controller uses the voltage received from the host through a power rail as a driving voltage without regulating the received voltage through a regulator.

The technical problems of the inventive concepts are not limited to the technical problems mentioned above, and other technical problems not mentioned are clearly understood by those skilled in the art from the descriptions below.

According to some aspects of the inventive concepts, there is provided a method of operating a storage system including a host and a device including generating, by the device, a regulated voltage based on a first voltage provided from the host and using the regulated voltage as a driving voltage for driving a device controller of the device, obtaining, by the host, driving voltage information of the device from the device, generating, by the host, a second voltage, based on the driving voltage information, and providing the generated second voltage to the device, and switching, by the device, the driving voltage to the second voltage.

According to some aspects of the inventive concepts, there is provided a method of operating a storage system including a host and a device including generating, by the device, a regulated voltage based on a first voltage provided from the host and using the regulated voltage as a driving voltage for driving a device controller of the device, causing at least one line connecting the host to the device to exit from a hibernation state, which is a power saving state, resetting the at least one line by transmitting a line reset signal through the at least one line, obtaining, by the host, driving voltage information based on the line reset signal received from the device, generating a second voltage, by the host, based on the driving voltage information and providing the generated second voltage to the device, and switching, by the device, the driving voltage to the second voltage.

According to some aspects of the inventive concepts, there is provided a device configured to communicate with a host including a device controller configured to operate based on driving voltage, a first power pin configured to receive a first voltage from the host; and a second power pin configured to receive a second voltage from the host, wherein the device controller comprises a voltage regulator generating a regulated voltage by lowering the first voltage, a switching circuit configured to output a voltage selected from the regulated voltage and the second voltage as a driving voltage, and a power control circuit configured to determine a voltage level of the second voltage and controls the switching circuit in response to receiving the second voltage from the host.

At least some of the above and other features of the invention are set out in the claims.

BRIEF DESCRIPTION OF THE DRAWINGS

Embodiments of the inventive concepts will be more clearly understood from the following detailed description taken in conjunction with the accompanying drawings in which:

FIG. 1 is a block diagram showing a storage system according to some example embodiments;
FIG. 2 is a block diagram illustrating a device according to some example embodiments;
FIGS. 3A and 3B are graphs showing voltages supplied to a device according to some example embodiments;
FIG. 4 is a flowchart illustrating a method of operating a storage system according to some example embodiments;
FIGS. 5A to 5D are flowcharts to explain an operation method of a storage system according to some example embodiments;
FIGS. 6A to 6C are flowcharts to explain an operation method of a storage system according to some example embodiments;

FIG. 7 is a flowchart to explain an operation method of a storage system according to some example embodiments;
FIG. 8 is a block diagram illustrating a storage system according to embodiments;
FIG. 9 is a diagram illustrating an interface between a host and a device of FIG. 8;
FIG. 10 is a diagram explaining a LINE state of FIG. 9;
FIG. 11 is a flowchart to explain an operation method of a storage system according to some example embodiments;
FIG. 12 is a drawing to explain a UFS system according to some example embodiments; and
FIGS. 13A to 13C are diagrams to explain a form factor of a UFS card.

DETAILED DESCRIPTION OF THE EMBODIMENTS

Hereinafter, some example embodiments of the inventive concepts are described in detail with reference to the attached drawings. When explaining with reference to drawings, identical or corresponding components are given the same drawing reference numerals and descriptions already given therefor are omitted.

FIG. 1 is a block diagram showing a storage system 10 according to some example embodiments.

Referring to FIG. 1, the storage system 10 may include a host 100, a device 200, and a first power rail PR1, a second power rail PR2, and a third power rail PR3.

In this specification, the host 100 and the device 200 may be connected to each other, for example, based on the conventions defined in the universal flash storage (UFS) specification (for instance, UFS version 4.1) announced by joint electron device engineering council (JEDEC), the M-physical layer (M-PHY) specification (for instance, MIPI M-PHY version 5.0) and the unified protocol (UniPro) specification (for instance, MIPI UniPro version 2.0) by the mobile industry processor interface (MIPI) alliance. Whilst specific specification versions are discussed herein, it will be appreciated that alternative embodiments may be in accordance with different versions of these specifications. In some example embodiments, the host 100 may be a UFS host, and the device 200 may be a UFS storage device. In some example embodiments, the host 100 may be referred to as a host device. In some example embodiments, the device 200 may be referred to as a storage device.

The host 100 may be implemented as a processor, such as a central processing unit (CPU), an application processor (AP), a system-on-a-chip (SoC), and may process data. The host 100 may execute an operating system (OS) and/or various applications.

The host 100 may include a host controller 110 and a power management integrated circuit (PMIC) 130. The host 100 may transmit a driving voltage information request VIQ to the device 200. The host 100 may receive a driving voltage information response VIR from the device 200.

In this specification, the driving voltage may refer to the voltage required or desired to operate a device controller 210. For example, the driving voltage may be a voltage required or desired to drive the logic circuit of the device controller 210. Also, for example, the driving voltage may be a voltage required or desired to drive the input/output circuit of the device controller 210. In some example embodiments, the driving voltage may be referred to as a logic voltage, an internal voltage, or an input/output voltage.

The host 100 may supply power to the device 200. The host 100 may generate a VCC voltage, a VCCQ voltage, and a VCCQL voltage through the PMIC 130. The host 100 may supply power to the device 200 by providing the VCC voltage, the VCCQ voltage, and the VCCQL voltage to the device 200. In this specification, the VCCQ voltage may be referred to as the first voltage, and the VCCQL voltage may be referred to as the second voltage. The VCC voltage may be referred to as the third voltage. As used herein, such terms as "first", "second" and "third" may be used to simply distinguish corresponding features (e.g. components, elements signals, or values) from each other, and need not limit the features in any other aspect (e.g., importance, size, magnitude, order, etc.).

In some example embodiments, the VCC voltage may be provided from the host 100 to the device 200 via the first power rail PR1. The VCCQ voltage may be provided from the host 100 to the device 200 via the second power rail PR2. The VCCQL voltage may be provided from the host 100 to the device 200 via the third power rail PR3.

In some example embodiments, the first power rail PR1, the second power rail PR2, and the third power rail PR3 may each be electrically connected to power pins provided in the device 200. For example, the first power rail PR1 may be electrically connected to the first power pin, the second power rail PR2 may be electrically connected to the second power pin, and the third power rail PR3 may be electrically connected to the third power pin. In this specification, the power pin may refer to a power receiving terminal through which the device 200 receives power from the host 100. A detailed explanation of this is provided below with reference to FIGS. 13A to 13C.

In some example embodiments, the host 100 may provide the VCCQ voltage to the storage device 200 when booting the storage system 10. The host 100 may request the device 200 to transmit driving voltage information by transmitting the driving voltage information request VIQ to the device 200. After the host 100 receives the driving voltage information response VIR from the device 200, the host 100 may generate a VCCQL voltage based on the driving voltage level indicated by the driving voltage information included in the driving voltage information response VIR, and provide the generated VCCQL voltage to the device 200.

The device 200 may store data provided by the host 100 and provide data stored in an internal storage space to the host 100. In some example embodiments, the device 200 may be a storage device implemented with UFS. The device 200 may include the device controller 210 and a non-volatile memory 230.

The device controller 210 may control the non-volatile memory 230 to write data to the non-volatile memory 230 or read data stored in the non-volatile memory 230 in response to a request from the host 100. In some example embodiments, the device controller 210 may control a write operation (or program operation), a read operation, and/or an erase operation to the non-volatile memory 230 by providing commands/addresses and/or control signals to the non-volatile memory 230. Additionally, data to be written and data to be read may be transmitted and received between the device controller 210 and the non-volatile memory 230.

The device controller 210 may operate based on at least one of the VCCQ voltage and the VCCQL voltage received from the host 100.

In some example embodiments, when the device controller 210 operates based on the VCCQ voltage, the device controller 210 may generate a regulated voltage by regulating the voltage level of the VCCQ voltage through a voltage regulator, and operate based on the regulated voltage. A regulated voltage may be a voltage having a different (e.g. lower) level then the voltage it is based on (e.g. the VCCQ voltage).

In some example embodiments, the device controller 210 may operate based on the VCCQL voltage. When the device controller 210 receives the VCCQL voltage, the device controller 210 may use the VCCQL voltage as a driving voltage of the device controller 210 without adjusting the voltage level of the VCCQL voltage through a regulator.

In some example embodiments, when booting the storage system 10, the device controller 210 may operate based on the VCCQ voltage received from the host 100. The VCCQL voltage may be generated after the host 100 receives the driving voltage information response VIR from the device 200. The device controller 210 may detect that the VCCQL voltage has been received from the host 100 and switch the driving voltage of the device controller 210 from the VCCQ voltage to the VCCQL voltage.

The non-volatile memory 230 may include a plurality of memory cells, for example, the plurality of memory cells may be flash memory cells. In some example embodiments, the plurality of memory cells may be NAND flash memory cells. However, the inventive concepts are not limited thereto, and in some example embodiments, the plurality of memory cells may be resistive memory cells, such as resistive RAM (ReRAM) memory cells, phase change RAM (PRAM) memory cells, or magnetic RAM (MRAM) memory cells.

In some example embodiments, the device 200 may be implemented as a DRAMless device, and the DRAMless device may refer to a device that does not include a DRAM (Dynamic Random Access Memory) cache. In this case, the device controller 210 may not include a DRAM controller. For example, the device 200 may use a portion of the non-volatile memory 230 as a buffer memory.

In some example embodiments, the device 200 may be an internal memory embedded in an electronic device. For example, the device 200 may be an embedded UFS memory device, an embedded multi-media card (eMMC), or a solid state drive (SSD). However, the inventive concepts are not limited thereto, and the device 200 may be a non-volatile memory (e.g., one time programmable ROM (OTPROM), programmable ROM (PROM), erasable and programmable ROM (EPROM), electrically erasable and programmable ROM (EEPROM), mask ROM, flash ROM, etc.). In some example embodiments, the device 200 may be an external memory that is removable from an electronic device. For example, the device 200 may include at least one of a UFS memory card, a compact flash (CF) card, a secure digital (SD) card, a micro secure digital (Micro-SD) card, a mini secure digital (Mini-SD) card, an extreme digital (xD) card, and/or a memory stick.

The storage system 10 may be implemented as an electronic device, such as a personal computer (PC), a laptop computer, a mobile phone, a smartphone, a tablet PC, a personal digital assistant (PDA), an enterprise digital assistant (EDA), a digital still camera, a digital video camera, an audio device, a portable multimedia player (PMP), a personal (or portable) navigation device (PND), an MP3 player, a handheld game console, or an e-book, for example. In addition, the storage system 10 may be implemented as various types of electronic devices, such as a wearable device such as a wristwatch or a head-mounted display (HMD).

According to some example embodiments, the host 100 may obtain driving voltage information of the device controller 210 from the device 200 and provide the VCCQL voltage generated based on the driving voltage information to the device 200. When the device 200 receives a VCCQL voltage from the host 100, the device 200 may improve the power efficiency of the device 200 by switching the driving voltage of the device controller 210 from the VCCQ voltage to the VCCQL voltage.

FIG. 2 is a block diagram illustrating a device 200 according to some example embodiments. FIGS. 3A and 3B are graphs showing voltages supplied to a device 200 according to some example embodiments. FIGS. 2 to 3B may be described with reference to FIG. 1, and the description already given may be omitted.

Referring to FIG. 2, the device 200 may include a device controller 210 and a non-volatile memory 230.

The device controller 210 may include a regulator 211, a switching circuit 212, a logic circuit 213, a power control circuit 214, and an interconnect portion 220.

The regulator 211 may receive a VCCQ voltage and generate a regulated voltage VR by regulating the VCCQ voltage. Regulating the VCCQ voltage may comprise converting the VCCQ voltage into the regulated voltage VR. The regulated voltage VR may be a lower VCCQ voltage. That is, the magnitude of the regulated voltage VR may be less than the magnitude of the VCCQ voltage. Accordingly, the regulator may generate the regulated voltage VR my reducing the magnitude of the VCCQ voltage. In some example embodiments, the regulator 211 may be a low drop out (LDO) regulator.

The switching circuit 212 may receive the regulated voltage VR from the regulator 211. The switching circuit 212 may receive a VCCQL voltage applied to the device 200 through the second power rail PR2 without passing through the regulator 211. In some example embodiments, the regulated voltage VR may be equal to or different from the magnitude of the VCCQL voltage.

The switching circuit 212 may select either a regulated voltage VR received through a first path PATH1 or a VCCQL voltage received through a second path PATH2, and output the selected voltage as a driving voltage VLG for driving the device controller 210. In this case, the switching circuit 212 may perform an operation of selecting either the regulated voltage VR received through the first path PATH1 or a VCCQL voltage received through a second path PATH2 based on the control of the power control circuit 214.

In this specification, the path from the first power rail PR1 to the switching circuit via the regulator 211 may be defined as the first path PATH1, and the path from the second power rail PR2 directly to the switching circuit 212 without going through the regulator 211 may be defined as the second path PATH2.

The driving voltage VLG output from the switching circuit 212 may be used to drive the logic circuit 213 by being applied to the logic circuit 213. In addition, the driving voltage VLG output from the switching circuit 212 may be used to drive the interconnect portion 220 by being applied to the interconnect portion 220.

The logic circuit 213 may refer to circuits that constitute the device controller 210 to process a command or request provided from the host 100.

The power control circuit 214 may include a voltage detector 215. The voltage detector 215 may detect whether the VCCQL voltage is applied to the device 200. In addition, the voltage detector 215 may detect a change in the VCCQL voltage that occurs after a power negotiation operation between the device 200 and the host 100. The power control circuit 214 may generate a power switching signal PSS in response to the voltage detector 215 detecting that the VCCQL voltage is applied to the device 200. Alternatively, the power control circuit 214 may generate the power switching signal PSS in response to the voltage detector 215 detecting that the VCCQL voltage has changed following a power negotiation operation between the device 200 and the host 100. The power switching signal PSS may be a signal that controls the switching circuit 212 to switch the voltage provided to the logic circuit 213 and the interconnect portion 220 from a regulated voltage VR to the VCCQL voltage. In this specification, power negotiation operation may refer to a series of operations in which the host 100 obtains driving voltage information from the device 200 and, based on the obtained driving voltage information, the host 100 provides the device 200 with the VCCQL voltage required or desired by the device 200.

The power control circuit 214 may receive a driving voltage information request VIQ from the host 100 through a host interconnect portion 221. The power control circuit 214 may, in response to receiving a driving voltage information request VIQ, provide a driving voltage information response VIR to the host 100 through the host interconnect portion 221. The driving voltage information response VIR may include driving voltage information, and the driving voltage information may be information indicating a driving voltage level that drives the device controller 210. In detail, the driving voltage level may mean the level of the logic voltage (or the level of the internal voltage) applied to drive the logic circuit 213 and the interconnect portion 220 of the device controller 210. The driving voltage level may be a voltage level sufficient or necessary to drive the logic circuit 213 and the interconnect portion 220. The voltage level may be large enough to drive the logic circuit 213 and the interconnect portion 220 and small enough not to damage any of the components in the logic circuit 213 and the interconnect portion 220.

The driving voltage information may be a value previously input into the device 200. In some example embodiments, the driving voltage information may be stored in the power control circuit 214. In some example embodiments, the driving voltage information may be stored in the interconnect portion 220.

The interconnect portion 220 may include the host interconnect portion 221 and a memory interconnect portion 222. The host interconnect portion 221 may be a circuit configured to process input/output signals between the host 100 and the device controller 210. The memory interconnect portion 222 may be a circuit configured to process input/output signals between the device controller 210 and the non-volatile memory 230. In this specification, the interconnect portion 220 may be referred to as an input/output circuit.

In some example embodiments, the host interconnect portion 221 may correspond to a UFS interconnect layer. The host interconnect portion 221 may include a physical layer and a link layer. The physical layer of the interconnect portion 220 may be defined by the M-PHY specification (for instance, M-PHY version 5.0), and the link layer of the interconnect portion 220 may be defined by the UniPro specification (for instance, MIPI UniPro version 2.0). Although not shown in FIG. 2, an interconnect portion included in the host 100 for communicating with the device 200 may also correspond to the UFS interconnect layer, such as the host interconnect portion 221 of the device 200.

In some example embodiments, the driving voltage information request VIQ may follow the format of the query request UFS protocol information unit (UPIU) defined in the UFS specification (for instance, as defined in UFS version 4.1), and the driving voltage information response VIR may follow the format of the query response UPIU defined in the UFS specification. A detailed description related to this is provided below with reference to FIGS. 5A to 5D.

In some example embodiments, the driving voltage information request VIQ may follow the format of NOP OUT UPIU defined in the UFS specification (for instance, as defined in UFS version 4.1), and the driving voltage information response VIR may follow the format of NOP IN UPIU defined in the UFS specification. A detailed description related to this is provided below with reference to FIGS. 6A to 6C.

In some example embodiments, the driving voltage information request VIQ may follow the format of the device management entity (DME) peer information acquisition request DME_PEER_GET.req defined in the MIPI UniPro specification (for instance, as defined in MIPI UniPro version 2.0), and the driving voltage information response VIR may follow the DME peer information acquisition response DME_PEER_GET.cnf defined in the MIPI UniPro specification. A detailed description related to this is provided below with reference to FIG. 7.

In some example embodiments, the driving voltage information request VIQ may follow the format of the hibernation state exit HIBERN8 EXIT signal and the line reset LINE RESET signal defined in the MIPI M-PHY specification (for instance, MIPI M-PHY version 5.0). Similarly, the driving voltage information response VIR may also follow the format of the hibernation state exit HIBERN8 EXIT signal and the line reset signal defined in the MIPI M-PHY specification (for instance, MIPI M-PHY version 5.0). A detailed description related to this is provided below with reference to FIG. 11.

Referring to FIGS. 2 and 3A, the device 200 may receive a VCC voltage through a first power rail PR1, a VCCQ voltage through a second power rail PR2, and a VCCQL voltage through a third power rail PR3. The VCC voltage may be applied to the non-volatile memory 230. The VCCQ voltage and the VCCQL voltage may be applied to the device controller 210. The first power rail PR1, the second power rail PR2, and the third power rail PR3 may be different (for example, distinct or separate) power rails. The VCC voltage may be a voltage supplied from the host 100 to the device 200 to drive the non-volatile memory 230. The VCCQ voltage and the VCCQL voltage may be voltages supplied from the host 100 to the device 200 to drive the device controller 210.

Referring to FIG. 3A, the horizontal axis of the graph shown in FIG. 3A may represent the time elapsed after booting of the storage system 10. The vertical axis of the graph illustrated in FIG. 3A may represent the voltage levels of the VCC voltage, the VCCQ voltage, and the VCCQL voltage. The voltage level of the VCC voltage may reach a first voltage level VL1 at a first time point T11. The voltage level of the VCCQ voltage may reach a second voltage level VL2 at the first time point T11. The host 100 may begin to supply the VCCQL voltage to the device 200 at a second time point T12. The voltage level of the VCCQL voltage may reach a third voltage level VL3 at a third time point T13.

In some example embodiments, from the first time point T11 to the second time point T12, the storage system 10 may perform the power negotiation operation. At the first time point T11, the host 100 may transmit the driving voltage information request VIQ to the device 200. After transmitting the driving voltage information request VIQ, the host 100 may receive a driving voltage information response VIR from the device 200 and generate a VCCQL voltage based on the driving voltage level included in the driving voltage information response VIR. At the second time point T12, the host 100 may supply the generated VCCQL voltage to the device 200. At the third time point T13, when the VCCQL voltage reaches the third voltage level VL3, the device 200 may detect this and control the switching circuit 212 to switch the output of the switching circuit 212, thereby causing the switching circuit 212 to output the driving voltage VLG.

In some example embodiments, the VCC voltage may be greater than the VCCQ voltage, and the VCCQ voltage may be greater than the VCCQL voltage. That is, the first voltage level VL1 may be greater than the second voltage level VL2 and the second voltage level VL2 may be greater than the third voltage level VL3.

In some example embodiments, the first voltage level VL1 may be about or exactly 2.5 V, the second voltage level VL2 may be about or exactly 1.2 V, and the third voltage level VL3 may be about or exactly 0.75 V, but these are examples and are not intended to limit the inventive concepts.

Referring to FIG. 3B, FIG. 3B shows that, unlike FIG. 3A, the host 100 applies all of the VCC voltage, the VCCQ voltage, and the VCCQL voltage to the device 200 from the time of booting. At the time point T11a, the voltage level of the VCC voltage may be a first voltage level VL1a, the voltage level of the VCCQ voltage may be a second voltage level VL2a, and the voltage level of the VCCQL voltage may be a third voltage level VL3a.

The host 100 may perform power negotiation operation with the device 200 from the first time point T11a to the second time point T12a. The host 100 may change the VCCQL voltage by changing the level from the third voltage level VL3a to the fourth voltage level VL4a based on the driving voltage information obtained through the power negotiation operation with the device 200. In this case, the fourth voltage level VL4a may correspond to the driving voltage level required or desired (e.g. specified) by the device controller 210.

In some example embodiments, the device 200 may operate based on the regulated voltage VR until the third time point T13a, and may operate based on the VCCQL voltage from the third time point T13a.

In some example embodiments, the voltage detector 215 may detect when the level of the VCCQL voltage changes from the third voltage level VL3a to the fourth voltage level VL4a and switch the output of the switching circuit 212.

The storage system 10 according to the embodiment improves the efficiency of power consumed by the device controller 210 by switching the driving voltage that drives the device controller 210 through the switching circuit 212. For example, it is assumed that the value of the VCCQ voltage is about or exactly 1.2 V, the value of the regulated voltage VR is about or exactly 0.75 V, and the value of the VCCQL voltage is about or exactly 0.75 V. When power is supplied to the device controller 210 along the first path PATH1, power loss may occur during the process in which the VCCQ voltage is lowered to a regulated voltage VR through the regulator 211. However, if the driving voltage VLG of the device controller 210 is supplied to the second path PATH2, the voltage conversion process through the regulator 211 may be omitted. In other words, by omitting the voltage conversion process through the regulator 211, the power efficiency of the device controller 210 is improved. For example, according to some example embodiments, there is an increase in speed, accuracy, resource efficiency and/or power efficiency of the device based on the above driving voltage methods. Therefore, the improved devices and methods overcome the deficiencies of the conventional devices and methods while reducing resource consumption, and/or improving data accuracy, and resource allocation (e.g., latency).

FIG. 4 is a flowchart illustrating a method of operating a storage system 10 according to some example embodiments FIG. 4 may be explained with reference to FIGS. 1 to 3, and the description already given may be omitted.

Referring to FIG. 4, in operation S110, the host 100 provides a VCCQ voltage to the device 200. The device controller 210 may generate a regulated voltage VR based on the VCCQ voltage received through the regulator 211. The device 200 may use the regulated voltage VR as a driving voltage VLG of the device controller 210.

In some example embodiments, the regulated voltage VR may be a voltage generated by the regulator 211 stepping down the VCCQ voltage.

In operation S120, the host 100 transmits a driving voltage information request VIQ to the device 200.

In operation S130, the device 200 transmits a driving voltage information response VIR to the host 100. The voltage information response VIR may include driving voltage information. The driving voltage information may be a value previously input into the device 200. The driving voltage information may indicate the driving voltage level.

In operation S140, the host 100 obtains driving voltage information based on the received driving voltage information response VIR and generates a VCCQL voltage based on the obtained driving voltage information.

In operation S150, the host 100 provides the generated VCCQL voltage to the device 200.

In operation S160, the device 200 switches the driving voltage VLG from the regulated voltage VR to the VCCQL voltage. The device 200 may detect the VCCQL voltage received from the host through the voltage detector 215. The device 200 may generate a power switching signal PSS in response to detecting that the VCCQL voltage is applied to the device 200. The device 200 may switch the driving voltage VLG from the regulated voltage VR to the VCCQL voltage by controlling the switching circuit 212 through the power switching signal PSS.

In some example embodiments, operations S110 to S160 may be performed when (e.g. during or in response to) booting the storage system 10.

FIGS. 5A to 5D are flowcharts to explain an operation method of a storage system 10 according to some example embodiments. In detail, FIGS. 5A to 5D are flowcharts to explain power negotiation operations between the host 100 and the device 200 using query request UPIUs and query response UPIUs based on the UFS specification. FIGS. 5A to 5D may be described with reference to FIGS. 1 to 4, and the description already given may be omitted. Hereinafter, the differences from FIG. 4 are explained.

Referring to FIG. 5A, operation S110a corresponds to operation S110 of FIG. 4. Operation S150a corresponds to operation S150 of FIG. 4. Operation S160a corresponds to operation S160 of FIG. 4.

In operation S120a, the host 100 transmits a driving voltage information request VIQ to the device 200. In this case, the driving voltage information request VIQ request may follow the format of a query request UPIU as defined in the UFS specification. That is, the host 100 may transmit the query request UPIU to the device 200. In operation S130a, the device 200 transmits a driving voltage information response VIR to the host 100. In this case, the driving voltage information response VIR may follow the format of a query response UPIU defined in the UFS specification. In other words, the device 200 may transmit the query response UPIU to the host 100.

According to the UFS specification, a UPIU may be data that is at least 32 bytes in size. '0 to 31' as indicated in UPIU may represent a 1 byte field. A UPIU may comprise a header and a number of transaction specific fields. The header may be 12 bytes in length. A UPIU may further comprise one or more extended header segments and zero or more data segments.

Referring to FIG. 5B, the query request UPIU may include an operation code (e.g., 'xx00 0110b'), flags, a task tag, a query function, total extra header segment (EHS) length, data segment length, transaction specific fields, a header end-to-end cyclic redundancy check (E2ECRC), and data E2ERC. Fields K to (K+Length-1) of the query request UPIU may include detailed data. The header E2ECRC, the data field, and the data E2ERC may be omitted in some cases.

Referring to FIG. 5C, the query response UPIU may include an operation code (e.g., 'xx11 0110b'), flags, a task tag, a query function, a query response, EHS length, device information, data segment length, transaction specific fields, a header E2ECRC, and data E2ERC. Fields K through (K+Length-1) of the query response UPIU may include detailed data. Header E2ECRC, data field, and data E2ERC may be omitted in some cases.

In this specification, fields 12 to 27 of the query request UPIU may be referred to as a first transaction specific field area TSF1. In this specification, the fields from K to (K+Length-1) of the query request UPIU may be referred to as a first payload area PL1.

In this specification, fields 12 to 27 of the query response UPIU may be referred to as a second transaction specific field area TSF2. In this specification, the fields from address K to (K+Length-1) of the query response UPIU may be referred to as the second payload area PL2.

In some example embodiments, the value of the query function field of the query request UPIU and query response UPIU may be 01h. The first transaction specific field area TSF1 and the second transaction specific field area TSF2 may correspond to a read descriptor operation code (OPCODE). In other words, the first transaction specific field area TSF1 of the query request UPIU may follow the format illustrated in FIG. 5B, and the second transaction specific field area TSF2 of the query response UPIU may also follow the format illustrated in FIG. 5B.

Referring to FIG. 5D, the transaction field area corresponding to the first transaction specific field area TSF1 and the second transaction specific field area TSF2 is illustrated. That is, the first transaction specific field area TSF1 and the second transaction specific field area TSF2 may include fields indicating a descriptor IDN, an index, a selector, and a length.

In some example embodiments, when the host 100 transmits the query request UPIU to the device 200, the value of the field (the 13th field of the query request UPIU) indicating the descriptor IDN of the first transaction specific field area TSF1 of the query request UPIU may be 00h, the value of the field (the 14th field of the query request UPIU) indicating the index may be 00h, and the value of the field (the 15th field of the query request UPIU) indicating the selector may be 2Bh. The first payload area PL1 may not include any values.

In some example embodiments, when the device 200 transmits the query response UPIU to the host 100, the value of the field (the 13th field of the query response UPIU) indicating the descriptor IDN of the second transaction specific field area TSF2 of the query response UPIU may be 00h, the value of the field (the 14th field of the query response UPIU) indicating the index may be 00h, and the value of the field (the 15th field of the query response UPIU) indicating the selector may be 2Bh. The second payload area PL2 may include a value corresponding to the driving voltage level.

In some example embodiments, the size of the second payload area PL2 for indicating the driving voltage level may be 1 byte, and the resolution of the driving voltage level may be about or exactly 0.01 V. For example, when the value of the second payload area PL2 is 0x0, this may indicate that the driving voltage level is about or exactly 0.9 V. When the value of the second payload area PL2 is 0x1, this may indicate that the driving voltage level is about or exactly 0.89 V. However, this is an example for illustrative purposes only and is not intended to limit the inventive concepts. For example, it is to be understood that the size of the second payload area PL2 may be greater than or less than 1 byte, and the resolution of the driving voltage may be about or exactly equal to, greater than, or less than 0.01 V.

Referring again to FIG. 5A, in operation S140a, the host 100 obtains driving voltage information based on the received query response UPIU and generates a VCCQL voltage based on the obtained driving voltage information.

FIGS. 6A to 6C are flowcharts to explain an operation method of a storage system 10 according to some example embodiments. In detail, FIGS. 6A to 6C are flowcharts to explain a power negotiation operations between a host 100 and a device 200 using NOP OUT UPIU and NOP IN UPIU according to the UFS specification. In this context, NOP may stand for no-operation. FIG. 6A to 6C may be described with reference to FIGS. 1 to 4, and descriptions already given may be omitted. Hereinafter, the differences from FIG. 4 are explained.

Referring to FIG. 6A, operation S110b corresponds to operation S110 of FIG. 4. Operation S150b corresponds to operation S150 of FIG. 4. Operation S160b corresponds to operation S160 of FIG. 4.

In operation S120b, the host 100 transmits a driving voltage information request VIQ to the device 200. In this case, the driving voltage information request VIQ may follow the format of NOP OUT UPIU defined in the UFS specification. In other words, the host 100 may send the NOP OUT UPIU to the device 200.

Referring to FIG. 6B, the NOP OUT UPIU may include an operation code (e.g., 'xx00 0000b'), flags, a task tag, total EHS length, data segment length, and a header E2ECRC. The header E2ECRC may be omitted in some cases.

In some example embodiments, the host 100 may request driving voltage information from the device 200 using at least one field among the reserved fields of the NOP OUT UPIU (addresses 2, 4 to 7, 9, 12 to 31 of the NOP OUT UPIU).

Referring again to FIG. 6A, in operation S130b, the device 200 transmits a driving voltage information response VIR to the host 100. In this case, the driving voltage information response VIR may follow the format of NOP IN UPIU defined in the UFS specification. In other words, the device 200 may transmit a NOP IN UPIU to the host 100.

Referring to FIG. 6C, the NOP IN UPIU may include an operation code (e.g., 'xx00 0000b'), flags, a task tag, total EHS length, device information, data segment length, and a header E2ECRC. The header E2ECRC may be omitted in some cases.

In some example embodiments, the device 200 may provide driving voltage information to the host 100 by using at least one field among the reserved fields of NOP IN UPIU (addresses 2, 4 to 7, 12 to 31 of NOP IN UPIU).

Referring again to FIG. 6A, in operation S140b, the host 100 obtains the driving voltage information based on the received NOP IN UPIU and generates a VCCQL voltage based on the obtained driving voltage information.

FIG. 7 is a flowchart to explain an operation method of a storage system 10 according to some example embodiments. In detail, FIG. 7 is a flowchart illustrating a power negotiation operation performed between a host 100 and a device 200 using a DME peer information acquisition request and a DME peer information acquisition response based on the UniPro specification. FIG. 7 may be explained with reference to FIGS. 1 to 4, and the description already given may be omitted. Hereinafter, the differences from FIG. 4 are explained.

Referring to FIG. 7, operation S110c corresponds to step S110 of FIG. 4. Operation S150c corresponds to operation S150 of FIG. 4. Operation S160c corresponds to operation S110 of FIG. 4.

In operation S120c, the host 100 transmits a driving voltage information request VIQ to the device 200. In this case, the driving voltage information request VIQ may follow the format of a DME peer information acquisition request DME_PEER_GET.req. In other words, the host 100 may transmit the DME peer information acquisition request to the device 200. The DME peer information acquisition request may be generated based on a DME defined in the UniPro standard.

The DME peer information acquisition request may be a request to acquire information of a peer device from a peer device. That is, through the DME peer information acquisition request, the host 100 may acquire information of the device 200. In this case, the DME peer information acquisition request may include a MIBattribute attribute value that indicates the type of information to be acquired. In this context, MIBattribute may stand for Management Information Base attribute.

In some example embodiments, the attribute value of the DME peer information acquisition request transmitted from the host 100 to the device 200 may be a value indicating that the requested information is driving voltage information. The attribute value may be expressed in 16 bits, for example 0x5006. However, this is an example for illustrative purposes only and is not intended to limit the inventive concepts.

In operation S130c, the device 200 transmits a driving voltage information response VIR to the host 100. In this case, the driving voltage information response VIR may follow the format of the DME peer information acquisition response DME_PEER_GET.cnf defined in the UniPro specification. In other words, the device 200 may transmit a DME peer information acquisition response to the host 100. The DME peer information acquisition response may be generated based on a DME defined in the UniPro standard.

The DME peer information acquisition response may be a response indicating information of a peer device provided in response to the DME peer information acquisition request. The DME peer information acquisition response may include a value indicating the driving voltage level of the device 200.

In operation S140c, the host 100 obtains driving voltage information based on the received DME peer information acquisition response and generates a VCCQL voltage based on the obtained driving voltage information.

FIG. 8 is a block diagram illustrating a storage system 10 according to embodiments. In detail, FIG. 8 is a drawing to explain a power negotiation operation between a host 100 and a device 200 using a hibernation state exit signal and a line reset signal according to the M-PHY specification. FIG. 8 may be explained with reference to FIGS. 1 to 3, and the descriptions already given may be omitted.

Referring to FIG. 8, the storage system 10 may include a host 100 and a device 200. In some example embodiments, a number of conceptual hardware configurations are illustrated that are included in the host 100 and device 200, but are not limited thereto and other configurations are possible. In FIG. 8, although the interconnect portion 120 is depicted as being located outside the host controller 110, the interconnect portion 120 may be configured to be included in the host controller 110. In addition, in FIG. 8, although the interconnect portion 220 is depicted as being located outside the device controller 210, the interconnect portion 220 may be configured to be included in the device controller 210.

The host 100 may include a host controller 110, an interconnect portion 120, and a PMIC 130. The interconnect portion 120 may provide an interface 300 between the host 100 and the device 200. The interconnect portion 120 may include physical components for exchanging data with the device 200, and may include at least one transmitter TX and at least one receiver RX. The interconnect portion 120 of the host 100 may include, for example, four transmitters TX1 to TX4 and four receivers RX1 to RX4.

The device 200 may include the device controller 210, the interconnect portion 220, and a non-volatile memory 230. The device controller 210 may control the non-volatile memory 230 to write data to the non-volatile memory 230 in response to a write request from the host 100, or control the non-volatile memory 230 to read data stored in the non-volatile memory 230 in response to a read request from the host 100.

The interconnect portion 220 may provide an interface 300 between the device 200 and the host 100. The interconnect portion 220 may include physical components for exchanging data with the host 100, and may include at least one receiver RX and at least one transmitter TX. The interconnect portion 220 of the device 200 may include, for example, four receivers RX1 to RX4 and four transmitters TX1 to TX4.

A transmitter TX included in the interconnect portion 120 of the host 100 and a receiver RX included in the interconnect portion 220 of the device 200 may be formed into one lane, as illustrated in FIG. 9. In addition, a transmitter TX included in the interconnect portion 220 of the device 200 and a receiver RX included in the interconnect portion 120 of the host 100 may also be formed as one lane. In some example embodiments, it is shown that the number of transmitters TX1 to TX4 and receivers RX1 to RX4 included in the interconnect portion 120 of the host 100 is the same as the number of receivers RX1 to RX4 and transmitters TX1 toTX4 included in the interconnect portion 220 of the device 200. According to some example embodiments, the number of transmitters TX and receivers RX included in the interconnect portion 120 of the host 100 may be different from the number of transmitters TX and receivers RX included in the interconnect portion 220 of the device 200.

FIG. 9 is a diagram illustrating an interface 300 between the host 100 and the device 200 of FIG. 8. The concepts of lane, line and link are described in the interface 300 of FIG. 9. Hereinafter, for convenience of explanation, among the plurality of transmitters and receivers included in the interconnect portions 120 and 220 of FIG. 8, the transmitter TX1 of the interconnect portion 220 of the device 200 and the receiver RX1 of the interconnect portion 120 of the host 100 are described as representative examples. FIG. 9 may be explained with reference to FIG. 8, and the description already given may be omitted.

Referring to FIG. 9, the interface 300 may support multiple lanes LANEs. Each lane is a unidirectional, single-signal, information-carrying transmission channel. The lane may consist of the transmitter TX1, the receiver RX1, and a line LINE that interconnects point-to-point between the transmitter TX1 and the receiver RX1. The transmitter TX1 or receiver RX1 has one differential output or input line interface corresponding to two signaling pins PINs. The pins PINs are individually labeled DP, indicating the positive node of the differential signal, and DN, indicating the negative node of the differential signal. Each of the DP and DN pins may be marked with an optional prefix TX or RX to indicate that it is a transmitter TX1 pin or a receiver RX1 pin. The line LINE consists of two differentially routed wires connecting the pins PINs of the transmitter TX1 and receiver RX1. These wires are transmission lines.

The interface 300 includes at least one lane LANE in each direction. The number of lanes LANEs in each direction need not be symmetrical. A link LINK may include one or more lanes LANEs in each direction and lane management portions 140 and 240 providing bidirectional data transfer capabilities. Although FIG. 9 illustrates that the lane management portions 140 and 240 and the controllers 110 and 210 are individually separated, the inventive concepts are not limited thereto, and the lane management portions 140 and 240 may be included in the controllers 110 and 210.

FIG. 10 is a diagram explaining the LINE state of FIG. 9 FIG. 10 may be explained with reference to FIGS. 1 to 3, and FIGS. 8 and 9, and descriptions already given may be omitted.

Referring to FIGS. 9 and 10, the line LINE may have a DIF-Z state with zero differential line voltage, a DIF-N state with negative differential line voltage, or a DIF-P state with positive differential line voltage. Alternatively, the line may have one of the following states: a DIF-Q state, which indicates a higher impedance state, and a DIF-X state, which is neither the DIF-N state nor the DIF-P state, although these states are not shown in FIG. 10. Here, the differential line voltage may be defined as the voltage of the line connected to the positive node minus the voltage of the line connected to the negative node. In this specification, the DIF-N state may be referred to as the first state, and the DIF-P state may be referred to as the second state.

On the line LINE between the transmitter TX1 and the receiver RX1, while the transmitter TX1 is in a hibernation state (hereinafter, referred to as "HIBERN8 state"), which is an ultra-low power saving state (e.g., more power than an off state and less power than an active state), the receiver RX1 may maintain the line LINE in a DIF-Z state. During the DIF-Z state from time point 1 T21 to time point 2 T22, the line LINE is in the HIBERN8 state. The time between time point 1 T21 and time point 2 T22 may be referred to as the hibernation interval $T_{HIBERN8}$.

At time point 2 T22, the transmitter TX1 may transition the line LINE to the DIF-N state to signal exit from the HIBERN8 state. In this case, the receiver RX1 may detect the DIF-N state of the line LINE and recognize that the link LINK on both the transmitter TX1 and the receiver RX1 is ready to be used and will have an exited HIBERN8 state. The time between the second time point T22 and the third time point T23 when the line LINE is in the DIF-N state may be referred to as the activation period $T_{ACTIVATE}$. In this specification, the transmitter TX1 transitioning the line LINE to the DIF-N state to signal an exit from the HIBERN8 state may be referred to as the transmitter TX1 transmitting a hibernation exit signal to the receiver RX1.

At time point 3 T23, the transmitter TX1 may transition the line LINE to the DIF-P state to signal a line reset. At this time, the receiver RX1 may detect the DIF-P state of the line LINE and recognize that both the transmitter TX1 and the receiver RX1 prepare for and perform a line reset. The time between the third time point T23 and the fourth time point T24 when the line LINE is in the DIF-P state may be referred to as the line-reset interval $T_{LINE\text{-}RESET}$, and the length of the line-reset interval $T_{LINE\text{-}RESET}$ may be referred to as the line reset length. In this specification, the transmitter TX1 transitioning the line LINE to the DIF-P state to signal a line reset may be referred to as the transmitter TX1 transmitting a line reset signal to the receiver RX1.

The host 100 may provide a driving voltage information request (FIG. 1, VIQ) to the device 200 to obtain driving voltage information from the device 200. In some example embodiments, the hibernation exit signal and line reset signal provided by the host 100 to the device 200 may be signals provided as a driving voltage information request VIQ.

The device 200 may provide a driving voltage information response (FIG. 1, VIR) in response to a driving voltage information request VIQ provided from the host 100. In some example embodiments, the hibernation exit signal and line reset signal provided by the device 200 to the host 100 may be signals provided as a driving voltage information response VIR.

The line reset length, which is the length of the line reset signal provided by the device 200 to the host 100, may correspond to the driving voltage information. In some example embodiments, because the driving voltage information indicates the driving voltage level of the device 200, the host 100 may generate a third voltage VCCQL through the PMIC 130 based on the following Equation 1 based on the received driving voltage information response VIR.

[Equation 1]

$$VCCQL = VREF + k * T_{LINE\text{-}RESET}$$

In Equation 1, VREF may mean a reference voltage, for example, about or exactly 0.5 V, but this is an example and is not intended to limit the inventive concepts. k may be a constant that determines the resolution of VCCQL and may be set depending on a value input to the device 200. That is, the driving voltage may be proportional to the line-reset interval $T_{LINE\text{-}RESET}$.

FIG. 11 is a flowchart to explain an operation method of a storage system according to some example embodiments. In detail, FIG. 11 is a flowchart to explain a power negotiation operation between the host 100 and the device 200 using a hibernation exit signal and a line reset signal according to the M-PHY specification. FIG. 11 may be explained with reference to FIGS. 1 to 3 and FIGS. 7 to 10, and descriptions already given may be omitted.

Referring to FIG. 11, in operation S210, the host 100 provides a VCCQ voltage to the device 200. The device controller 210 may generate a regulated voltage VR based on the VCCQ voltage received through the regulator 211. The device 200 may use the regulated voltage VR as the driving voltage VLG of the device controller 210 and the interconnect portion 220.

Operations S220 and S230 may be operations for escaping at least one line connecting the host 100 and the device 200 from the hibernation state. In detail, in operation S220, the host 100 transmits a hibernation state exit signal to the device 200. In operation S230, the device 200 transmits the hibernation state exit signal to the host 100.

Operations S240 and S250 may be operations for resetting at least one line connecting the host 100 to the device 200 in operations S220 and S230. In detail, in operation S240, the host 100 transmits a line reset signal to the device 200. In some example embodiments, when the host 100 transmits the line reset signal to the device 200, the state of the first line connecting the host 100 to the device 200 may transition from the DIF-N state to the DIF-P state, as illustrated in FIG. 10. In operation S250, the device 200 transmits a line reset signal to the host 100. In some example embodiments, when the device 200 transmits the line reset signal to the host 100, the state of the second line connecting the host 100 to the device 200 may transition from the DIF-N state to the DIF-P state, as illustrated in FIG. 10. In this case, the line reset length, which is the length of the time period during which the state of the second line is maintained in the DIP-P state, may correspond to the driving voltage information of the device 200.

In operation S260, the host 100 obtains driving voltage information based on the received line reset signal. In detail, the host 100 may obtain driving voltage information of the device 200 based on the length of the received line reset signal, e.g., the line reset length, and generate a VCCQL voltage having a voltage level indicated by the driving voltage information.

In some example embodiments, the magnitude of the VCCQL voltage generated by the host 100 may be calculated based on the Equation 1 described above. For instance, the magnitude of the VCCQL voltage generated by the host 100 may be proportional to the length of the line reset signal received by the host 100.

In operation S270, the host 100 provides the generated VCCQL voltage to the device 200.

In operation S280, the device 200 detects the VCCQL voltage received from the host through the voltage detector 215. The device 200 may generate a power switching signal PSS in response to detecting that the VCCQL voltage has been applied to the device 200. The device 200 may switch the driving voltage VLG from a regulated voltage VR to a VCCQL voltage by controlling a switching circuit 212 via a power switching signal PSS.

FIG. 12 is a drawing to explain a UFS system 2000 according to some example embodiments.

The UFS system 2000 is a system that follows the UFS standard announced by JEDEC and may include a UFS host 2100, a UFS device 2200, and a UFS interface 2300. The description of the system 10 of FIG. 1 described above may also be applied to the UFS system 2000 of FIG. 12, to the extent that it does not conflict with the following description of FIG. 12.

Referring to FIG. 12, the UFS host 2100 and the UFS device 2200 may be connected to each other through the UFS interface 2300.

The UFS host 2100 may include a UFS host controller 2110, an application 2120, a UFS driver 2130, a host memory 2140, and a UFS interconnect (UIC) layer 2150. The UFS device 2200 may include a UFS device controller 2210, a non-volatile storage 2220, a storage interface 2230, a device memory 2240, a UIC layer 2250, and a regulator 2260. The non-volatile storage 2220 may be composed of a plurality of storage units 2221, and the storage units 2221 may include a vertical NAND (V-NAND) flash memory having a 2D structure or a 3D structure, but may also include other types of non-volatile memory, such as PRAM and/or ReRAM. The UFS device controller 2210 and the non-volatile storage 2220 may be connected to each other through the storage interface 2230. The storage interface 2230 may be implemented to comply with standard protocols such as Toggle or ONFI.

The application 2120 may mean a program that desires to communicate with the UFS device 2200 to utilize the functions of the UFS device 2200. The application 2120 may send an input-output request IOR to the UFS driver 2130 for input/output to the UFS device 2200. Then input/output request IOR may mean, but is not necessarily limited to, a request to read data, a request to write data, and/or a request to discard data.

The UFS driver 2130 may manage the UFS host controller 2110 through a UFS-host controller interface (UFS-HCI). The UFS driver 2130 may convert input/output requests generated by the application 2120 into UFS commands defined by the UFS standard and transmit the UFS commands to the UFS host controller 2110. A single I/O request may be translated into multiple UFS commands. UFS commands may be commands defined primarily by the Small Computer System Interface (SCSI) standard, but may also be commands specific to the UFS standard.

The UFS host controller 2110 may transmit the UFS command converted by the UFS driver 2130 to the UIC layer 2250 of the UFS device 2200 through a UIC layer 2150 and the UFS interface 2300. In this process, a UFS host register 2111 of the UFS host controller 2110 may serve as a command queue CQ.

The UIC layer 2150 of the UFS host 2100 may include a MIPI M-PHY 2151 and a MIPI UniPro 2152, and the UIC layer 2250 of the UFS device 2200 may also include a MIPI M-PHY 2251 and a MIPI UniPro 2252.

The UFS interface 2300 may include a line transmitting a reference clock REF_CLK, a line transmitting a hardware reset signal RESET_n for the UFS device 2200, a pair of lines transmitting a differential input signal pair DIN_t and DIN_c, and a pair of lines transmitting a differential output signal pair DOUT_t and DOUT_c.

The frequency value of the reference clock REF_CLK provided from the UFS host 2100 to the UFS device 2200 may be one of four values: 19.2 MHz, 26 MHz, 38.4 MHz, and 52 MHz, but is not necessarily limited thereto. The UFS host 2100 may change the frequency value of the reference clock REF_CLK even while in operation, that is, while data transmission and reception is performed between the UFS host 2100 and the UFS device 2200. The UFS device 2200 may generate clocks of various frequencies from a reference clock REF_CLK provided from the UFS host 2100 using a phase-locked loop (PLL), etc. In addition, the UFS host 2100 may also set the data rate value between the UFS host 2100 and the UFS device 2200 through the frequency value of the reference clock REF_CLK. That is, the value of the above data rate may be determined depending on the frequency value of the reference clock REF_CLK.

The UFS interface 2300 may support multiple lanes, and each lane may be implemented as a differential pair. For example, the UFS interface 2300 may include one or more receiving lanes and one or more transmitting lanes. In FIG. 12, a pair of lines transmitting a differential input signal pair DIN_T and DIN_C may constitute the receiving lane, and a pair of lines transmitting a differential output signal pair DOUT_T and DOUT_C may constitute the transmitting lane. Although FIG. 12 illustrates one transmitting lane and one receiving lane, the number of transmitting lanes and receiving lanes may be changed.

The receiving lane and the transmitting lane may transmit data in a serial communication manner, and full-duplex communication between the UFS host 2100 and the UFS device 2200 is possible due to the structure in which the receiving lane and the transmitting lane are separated. That is, the UFS device 2200 may transmit data to the UFS host 2100 through the transmitting lane while receiving data from the UFS host 2100 through the receiving lane. In addition, control data, such as commands from the UFS host 2100 to the UFS device 2200, and user data that the UFS host 2100 wants to store in or read from the non-volatile storage 2220 of the UFS device 2200 may be transmitted through the same lane. Accordingly, a pair of receiving lanes and a pair of transmitting lanes between the UFS host 2100 and the UFS device 2200 may be all that is desired rather than including additional lanes for data transmission (for example, there may be no separate lane for data transmission in some example embodiments).

The UFS device controller 2210 of the UFS device 2200 may control the overall operation of the UFS device 2200. The UFS device controller 2210 may manage the non-volatile storage 2220 through a logical unit (LU) 2211, which is a logical data storage unit. The number of LUs 2211 may be 8, but is not limited thereto. The UFS device controller 2210 may include a flash translation layer (FTL) and may use address mapping information of the FTL to convert a logical data address, such as a logical block address (LBA), transmitted from the UFS host 2100 into a physical data address, such as a physical block address (PBA). In the UFS system 2000, a logical block for storing user data may have a size within a predetermined range. For example, the minimum size of a logical block may be set to 4 Kbytes.

When a command from the UFS host 2100 is input to the UFS device 2200 through the UIC layer 2250, the UFS device controller 2210 may perform an operation depending on the input command, and when the operation is completed, the UFS device controller 2210 may transmit a completion response to the UFS host 2100.

As an example, when the UFS host 2100 wants to store user data in the UFS device 2200, the UFS host 2100 may transmit a data storage command to the UFS device 2200. When a response ready-to-transfer indicating that user data is ready to be transferred is received from the UFS device 2200, the UFS host 2100 may transfer the user data to the UFS device 2200. The UFS device controller 2210 may temporarily store the received user data in the device memory 2240, and store the user data temporarily stored in the device memory 2240 in a selected location of the non-volatile storage 2220 based on the address mapping information of the FTL.

As another example, when the UFS host 2100 wants to read user data stored in the UFS device 2200, the UFS host 2100 may transmit a data read command to the UFS device 2200. The UFS device controller 2210 that receives the command may read user data from the non-volatile storage 2220 based on the data read command and temporarily store the read user data in the device memory 2240. During this read process, the UFS device controller 2210 may detect and correct errors in read user data using a built-in error correction code (ECC) circuit (not shown). Additionally, the UFS device controller 2210 may transmit user data temporarily stored in the device memory 2240 to the UFS host 2100. In addition, the UFS device controller 2210 may further include an advanced encryption standard (AES) circuit (not shown), and the AES circuit may encrypt or decrypt data input to the UFS device controller 2210 using a symmetric key algorithm.

The UFS host 2100 may sequentially store commands to be transmitted to the UFS device 2200 in the UFS host register 2111 that may function as a command queue and transmit the commands to the UFS device 2200 in the sequential order. In this case, the UFS host 2100 may transmit the next command waiting in the command queue to the UFS device 2200 even if the previously transmitted command is still being processed by the UFS device 2200, that is, even before receiving a notification that the previously transmitted command has been completed by the UFS device 2200, and accordingly, the UFS device 2200 may also receive the next command from the UFS host 2100 even while processing the previously transmitted command. The maximum number of commands that may be stored in such a command queue, queue depth, may be, for example, 32. In addition, the command queue may be implemented as a circular queue type, with a head pointer and a tail pointer indicating the start and end of the command sequence stored in the queue, respectively.

Each of the plurality of storage units 2221 may include a memory cell array and a control circuit that controls the operation of the memory cell array. The above memory cell array may include a two-dimensional memory cell array or a three-dimensional memory cell array. A memory cell array may include a plurality of memory cells, each memory cell may be a cell that stores 1 bit of information (single level cell, SLC) but may also be a cell that stores 2 or more bits of information, such as a multi-level cell (MLC), a triple level cell (TLC), or a quadruple level cell (QLC). The three-dimensional memory cell array may include vertical NAND strings that are vertically oriented such that at least one memory cell is positioned above another memory cell.

The UFS device 2200 may be input with power voltages such as VCC voltage, VCCQ voltage, and VCCQL voltage. The VCC voltage is the main power voltage for the UFS device 2200 and may have a value of about or exactly 2.4 to about or exactly 3.6 V. The VCCQ voltage and the VCCQL voltage are power supply voltages for supplying lower-range voltages (e.g. voltages that are less than the VCC voltage) and may be voltages supplied primarily for the UFS device controller 2210. The VCC voltage and VCCQ voltage may be supplied to each component of the UFS device 2200 through the regulator 2260. The regulator 2260 may be implemented as a set of unit regulators each connected to a different one of the aforementioned power supply voltages. The VCCQL voltage may be supplied to each component of the UFS device 2200 without passing through the regulator 2260. In some example embodiments, the VCCQ voltage may correspond to the VCCQ voltage disclosed in FIGS. 1 to 11.

FIGS. 13A to 13C are diagrams to explain a form factor of a UFS card. When the UFS device 2200 described with reference to FIG. 12 is implemented in the form of a UFS card 4000, the external appearance of the UFS card 4000 may follow that illustrated in FIGS. 13A to 13C.

FIG. 13A shows an example of a top view of the UFS card 4000. Referring to FIG. 13A, it may be seen that the UFS card 4000 follows an overall shark-shaped design. With respect to FIG. 13A, the UFS card 4000 may have dimension values as described in Table 1 below.

[Table 1]

| item | dimension (mm) |
|---|---|
| T1 | 9.70 |
| T2 | 15.00 |
| T3 | 11.00 |
| T4 | 9.70 |
| T5 | 5.15 |
| T6 | 0.25 |
| T7 | 0.60 |
| T8 | 0.75 |
| T9 | R0.80 |

FIG. 13B illustrates an example side view of the UFS card 4000. With respect to FIG. 13B, the UFS card 4000 may have dimension values as described in Table 2 below.

[Table 2]

| item | dimension (mm) |
|---|---|
| S1 | 0.74±0.06 |
| S2 | 0.30 |
| S3 | 0.52 |
| S4 | 1.20 |
| S5 | 1.05 |
| S6 | 1.00 |

FIG. 13C illustrates an example of a bottom view of the UFS card 4000. Referring to FIG. 13C, a plurality of pins may be formed on the bottom of the UFS card 4000 for electrical contact with the UFS slot, and the function of each pin is described below. Based on the symmetry between the top and bottom surfaces of the UFS card 4000, some of the dimensional information (e.g., T1 to T5 and T9) described with reference to FIG. 13A and Table 1 may also be applied to the bottom view of the UFS card 4000 as illustrated in FIG. 13C.

A plurality of pins may be formed on the bottom surface of the UFS card 4000 for electrical connection with the UFS host, and according to FIG. 13C, the total number of pins may be 12. Each pin may have a rectangular shape, and the signal name corresponding to the pin is as shown in Fig. 13C. For a brief description of each pin, see Table 3 below, and also refer to the description given above in connection with FIG. 12.

[Table 3]

| number | signal name | description | dimension (mm) |
|---|---|---|---|
| 1 | VSS | ground (GND) | 3.00 × 0.72 ±0.05 |
| 2 | DIN_C | differential input signal from the host to the UFS card 4000 (DIN_C is negative node, and DIN_T is positive node) | 1.50 × 0.72 ±0.05 |
| 3 | DIN_T | | |
| 4 | VSS | same as number 1 | 3.00 × 0.72 ±0.05 |
| 5 | DOUT_C | differential output signal output from UFS card 4000 to host (DOUT_C is negative node, and DOUT_T is positive node) | 1.50 × 0.72 ±0.05 |
| 6 | DOUT_T | | |
| 7 | VSS | same as number 1 | 3.00 × 0.72 ±0.05 |
| 8 | REF_CLK | reference clock provided by the host to the UFS card 4000 | 1.50 × 0.72 ±0.05 |
| 9 | VCCQ2 | a power supply voltage with a relatively low value compared to Vcc, mainly provided for the PHY interface or controller. | 3.00 × 0.72 ±0.05 |
| 10 | C/D(GND) | signal for card detection | 1.50 × 0.72 ±0.05 |
| 11 | VSS | same as number 1 | 3.00 × 0.80 ±0.05 |
| 12 | Vcc | main power voltage | |

In some example embodiments, the power pin corresponding to the VCCQ2 voltage may be used as a power pin for the VCCQL voltage.

In some example embodiments, the bottom of the UFS card 4000 may further have power pins for the VCCQ voltage and the VCCQL voltage.

Any or all of the elements described with reference to the figures may communicate with any or all other elements described with reference to figures. For example, any element may engage in one-way and/or two-way and/or broadcast communication with any or all other elements in the figures, to transfer and/or exchange and/or receive information such as but not limited to data and/or commands, in a manner such as in a serial and/or parallel manner, via a bus such as a wireless and/or a wired bus (not illustrated). The information may be in encoded various formats, such as in an analog format and/or in a digital format.

When the terms "about" or "substantially" are used in this specification in connection with a numerical value, it is intended that the associated numerical value includes a manufacturing or operational tolerance (e.g., ±10 %) around the stated numerical value. Moreover, when the words "generally" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10 %) around the stated numerical values or shapes.

As described herein, any electronic devices and/or portions thereof according to any of the example embodiments may include, may be included in, and/or may be implemented by one or more instances of processing circuitry such as hardware including logic circuits; a hardware/software combination such as a processor executing software; or any combination thereof. For example, the processing circuitry more specifically may include, but is not limited to, a central processing unit (CPU), an arithmetic logic unit (ALU), a graphics processing unit (GPU), an application processor (AP), a digital signal processor (DSP), a microcomputer, a field programmable gate array (FPGA), and programmable logic unit, a microprocessor, application-specific integrated circuit (ASIC), a neural network processing unit (NPU), an Electronic Control Unit (ECU), an Image Signal Processor (ISP), and the like. In some example embodiments, the processing circuitry may include a non-transitory computer readable storage device (e.g., a memory), for example a DRAM device, storing a program of instructions, and a processor (e.g., CPU) configured to execute the program of instructions to implement the functionality and/or methods performed by some or all of any devices, systems, modules, units, controllers, circuits, architectures, and/or portions thereof according to any of the example embodiments, and/or any portions thereof.

Embodiments are set out in the following Clauses:

Clause 1. A method of operating a storage system including a host and a device, the method comprising:

> generating, by the device, a regulated voltage based on a first voltage provided from the host and using the regulated voltage as a driving voltage for driving a device controller of the device;
> obtaining, by the host, driving voltage information of the device from the device;
> generating, by the host, a second voltage, based on the driving voltage information, and providing the generated second voltage to the device; and
> switching, by the device, the driving voltage to the second voltage.

Clause 2. The method of Clause 1, wherein a voltage level of the second voltage is lower than a voltage level of the first voltage.

Clause 3. The method of Clause 1 or Clause 2, wherein the generating of a regulated voltage and the using of the regulated voltage as a driving voltage comprises:

> generating, by the device, the regulated voltage by lowering the first voltage; and
> driving, by the device, a logic circuit or an input/output circuit of the device based on the regulated voltage.

Clause 4. The method of any preceding Clause, wherein

> the obtaining of driving voltage information of the device comprises
>
> > transmitting, by the host, a driving voltage information request to the device; and
> > transmitting, by the device, a driving voltage information response to the host in response to the driving voltage information request, and
>
> the driving voltage information indicates a voltage level of the driving voltage.

Clause 5. The method of Clause 4, wherein

> the drive voltage information request corresponds to a query request universal flash storage protocol information units (UPIU), and
> the drive voltage information response corresponds to a query response UPIU.

Clause 6. The method of Clause 4 or Clause 5, wherein

the drive voltage information request corresponds to NOP OUT universal flash storage protocol information units (UPIU), and
the drive voltage information response corresponds to NOP IN UPIU.

Clause 7. The method of Clause 4, wherein

the driving voltage information request corresponds to a peer information acquisition request generated based on a device management entity (DME) defined in a unified protocol standard, and
the driving voltage information response corresponds to a peer response generated based on the DME defined in the unified protocol standard.

Clause 8. The method of any preceding Clause, wherein the switching of the driving voltage to the second voltage comprises switching, by the device, the driving voltage from the regulated voltage to the second voltage in response to receiving the second voltage.

Clause 9. A device configured to communicate with a host, the device comprising:

a device controller configured to operate based on driving voltage;
a first power pin configured to receive a first voltage from the host; and
a second power pin configured to receive a second voltage from the host,
wherein the device controller comprises

a voltage regulator generating a regulated voltage by lowering the first voltage;
a switching circuit configured to output a voltage selected from the regulated voltage and the second voltage as a driving voltage; and
a power control circuit configured to determine a voltage level of the second voltage and control the switching circuit in response to receiving the second voltage from the host.

Clause 10. The device of Clause 9, wherein a voltage level of the second voltage is lower than a voltage level of the first voltage.

Clause 11. The device of Clause 9 or Clause 10, wherein

the first voltage provided to the device through the first power pin is applied to the voltage regulator, and
the second voltage provided to the device through the second power pin is applied to the switching circuit.

Clause 12. The device of any of Clauses 9-11, wherein

the host is configured to generate a third voltage greater than the first voltage, and
the device further comprises a third power pin configured to receive the third voltage from the host; and a non-volatile memory device operating based on the third voltage.

Clause 13. The device of Clause 12, wherein

the device controller comprises a logic circuit configured to operate based on the driving voltage; and an interconnect portion configured to operate based on the driving voltage,
the interconnect portion comprises a host interconnect portion configured to transmit and receive signals to and from the host; and a memory interconnect portion configured to transmit and receive signals to and from the non-volatile memory device.

Clause 14. The device of any of Clauses 9-13, wherein

the power control circuit is configured to, in response to a driving voltage information request received from the host, transmit a driving voltage information response to the host,
the driving voltage information indicates a voltage level of the driving voltage that drives the device controller.

Clause 15. The device of any of Clauses 9-14, wherein the power control circuit is configured to determine a voltage level of the second voltage based on a voltage level information input to the power control circuit in response to the device booting and provide driving voltage information including voltage level information of the determined second voltage to the host.

While the inventive concepts have been particularly shown and described with reference to embodiments thereof, it will be understood that various changes in form and details may be made therein without departing from the scope of the following claims.

## Claims

1. A method of operating a storage system including a host and a device, the method comprising:

    generating, by the device, a regulated voltage based on a first voltage provided from the host and using the regulated voltage as a driving voltage for driving a device controller of the device;
    obtaining, by the host, driving voltage information of the device from the device;
    generating, by the host, a second voltage, based on the driving voltage information, and providing the generated second voltage to the device; and
    switching, by the device, the driving voltage to the second voltage.

2. The method of claim 1, wherein a voltage level of the second voltage is lower than a voltage level of the first voltage.

3. The method of claim 1 or claim 2, wherein the generating of a regulated voltage and the using of the regulated voltage as a driving voltage comprises:

    generating, by the device, the regulated voltage by lowering the first voltage; and
    driving, by the device, a logic circuit or an input/output circuit of the device based on the regulated voltage.

4. The method of any preceding claim, wherein

    the obtaining of driving voltage information of the device comprises

        transmitting, by the host, a driving voltage information request to the device; and
        transmitting, by the device, a driving voltage information response to the host in response to the driving voltage information request, and

    the driving voltage information indicates a voltage level of the driving voltage.

5. The method of claim 4, wherein

    the driving voltage information request corresponds to a query request universal flash storage protocol information unit, hereinafter referred to as UPIU, and
    the driving voltage information response corresponds to a query response UPIU.

6. The method of claim 4 or claim 5, wherein

    the driving voltage information request corresponds to NOP OUT UPIU, and
    the driving voltage information response corresponds to NOP IN UPIU.

7. The method of claim 4, wherein

    the driving voltage information request corresponds to a peer information acquisition request generated based on a device management entity, hereinafter referred to as DME, defined in a unified protocol standard, and
    the driving voltage information response corresponds to a peer response generated based on the DME defined in the unified protocol standard.

8. The method of any preceding claim, wherein the switching of the driving voltage to the second voltage comprises switching, by the device, the driving voltage from the regulated voltage to the second voltage in response to receiving the second voltage.

**9.** A device configured to communicate with a host, the device comprising:

a device controller configured to operate based on driving voltage;
a first power pin configured to receive a first voltage from the host; and
a second power pin configured to receive a second voltage from the host,
wherein the device controller comprises

a voltage regulator configured to generate a regulated voltage by lowering the first voltage;
a switching circuit configured to output a voltage selected from the regulated voltage and the second voltage as a driving voltage; and
a power control circuit configured to determine a voltage level of the second voltage and control the switching circuit in response to receiving the second voltage from the host.

**10.** The device of claim 9, wherein a voltage level of the second voltage is lower than a voltage level of the first voltage.

**11.** The device of claim 9 or claim 10, wherein

the voltage regulator is configured to receive the first voltage provided to the device through the first power pin, and
the switching circuit is configured to receive the second voltage provided to the device through the second power pin.

**12.** The device of any of claims 9-11, wherein
the device further comprises:

a third power pin configured to receive a third voltage from the host, wherein the third voltage is greater than the first voltage; and
a non-volatile memory device configured to operate based on the third voltage.

**13.** The device of claim 12, wherein the device controller comprises:

a logic circuit configured to operate based on the driving voltage; and
an interconnect portion configured to operate based on the driving voltage, wherein the interconnect portion comprises a host interconnect portion configured to transmit and receive signals to and from the host and a memory interconnect portion configured to transmit and receive signals to and from the non-volatile memory device.

**14.** The device of any of claims 9-13, wherein the power control circuit is configured to, in response to a driving voltage information request received from the host, transmit a driving voltage information response to the host, wherein the driving voltage information response indicates a voltage level of the driving voltage that drives the device controller.

**15.** The device of any of claims 9-14, wherein the power control circuit is configured to determine a voltage level of the second voltage based on a voltage level information input to the power control circuit in response to the device booting and provide driving voltage information including voltage level information of the determined second voltage to the host.

FIG. 1

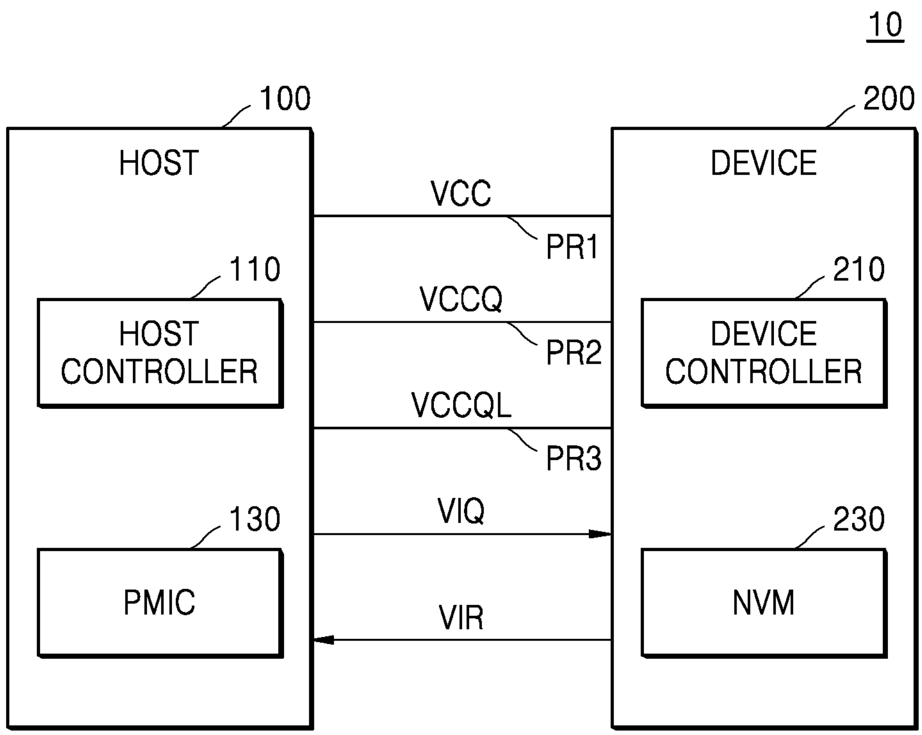
10
100
HOST
110
HOST CONTROLLER
130
PMIC
200
DEVICE
210
DEVICE CONTROLLER
230
NVM
VCC
PR1
VCCQ
PR2
VCCQL
PR3
VIQ
VIR

FIG. 2

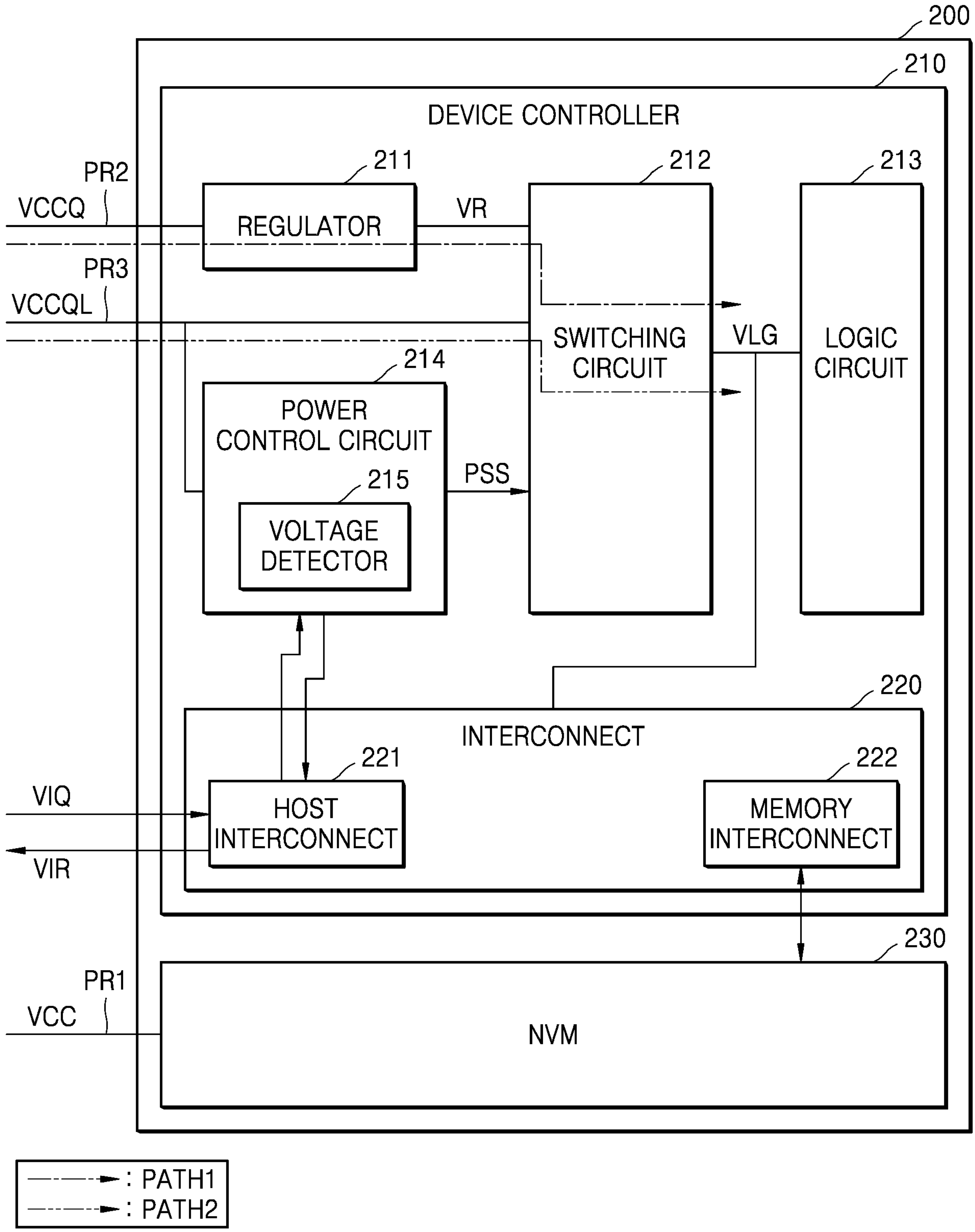
200
210
DEVICE CONTROLLER
211
REGULATOR
VR
212
SWITCHING CIRCUIT
213
LOGIC CIRCUIT
PR2
VCCQ
PR3
VCCQL
VLG
214
POWER CONTROL CIRCUIT
215
VOLTAGE DETECTOR
PSS
220
INTERCONNECT
221
HOST INTERCONNECT
222
MEMORY INTERCONNECT
VIQ
VIR
230
NVM
PR1
VCC
: PATH1
: PATH2

FIG. 3A

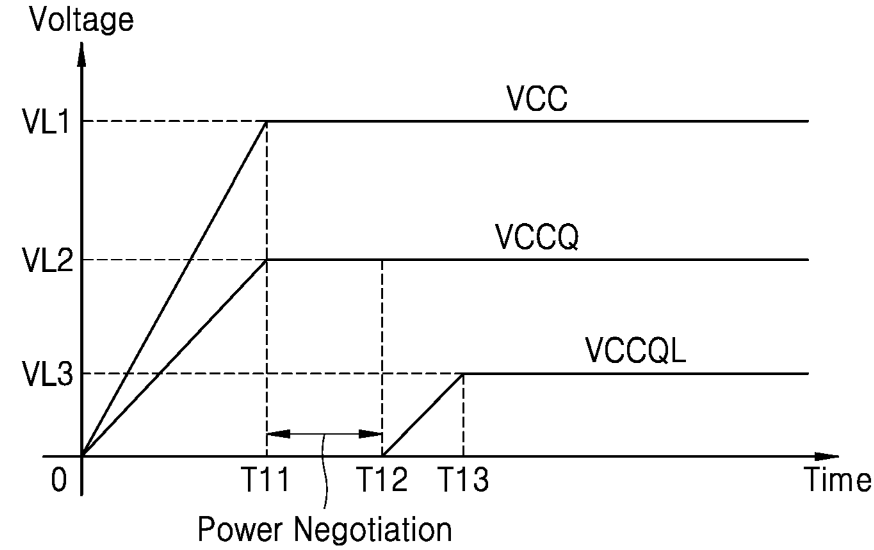
Voltage
VL1
VL2
VL3
VCC
VCCQ
VCCQL
0
T11
T12
T13
Time
Power Negotiation

FIG. 3B

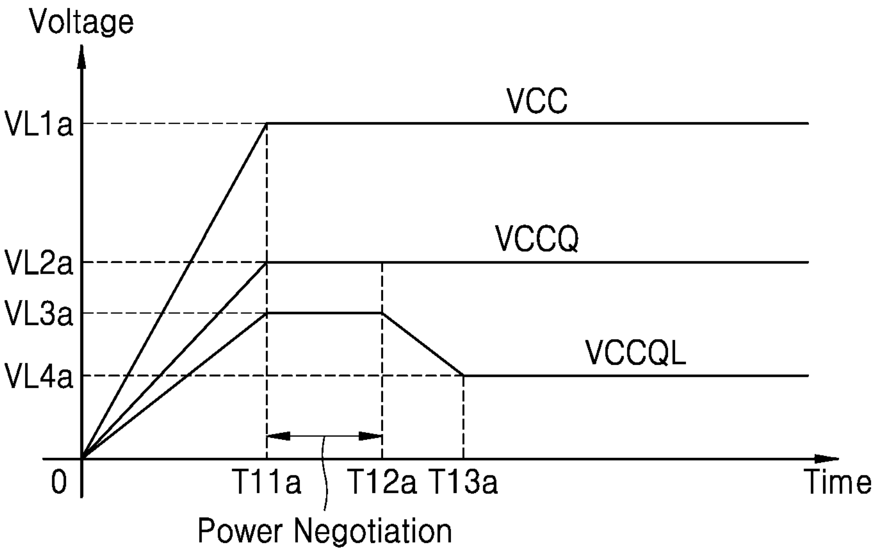
Voltage
VL1a
VL2a
VL3a
VL4a
VCC
VCCQ
VCCQL
0
T11a
T12a
T13a
Time
Power Negotiation

FIG. 4

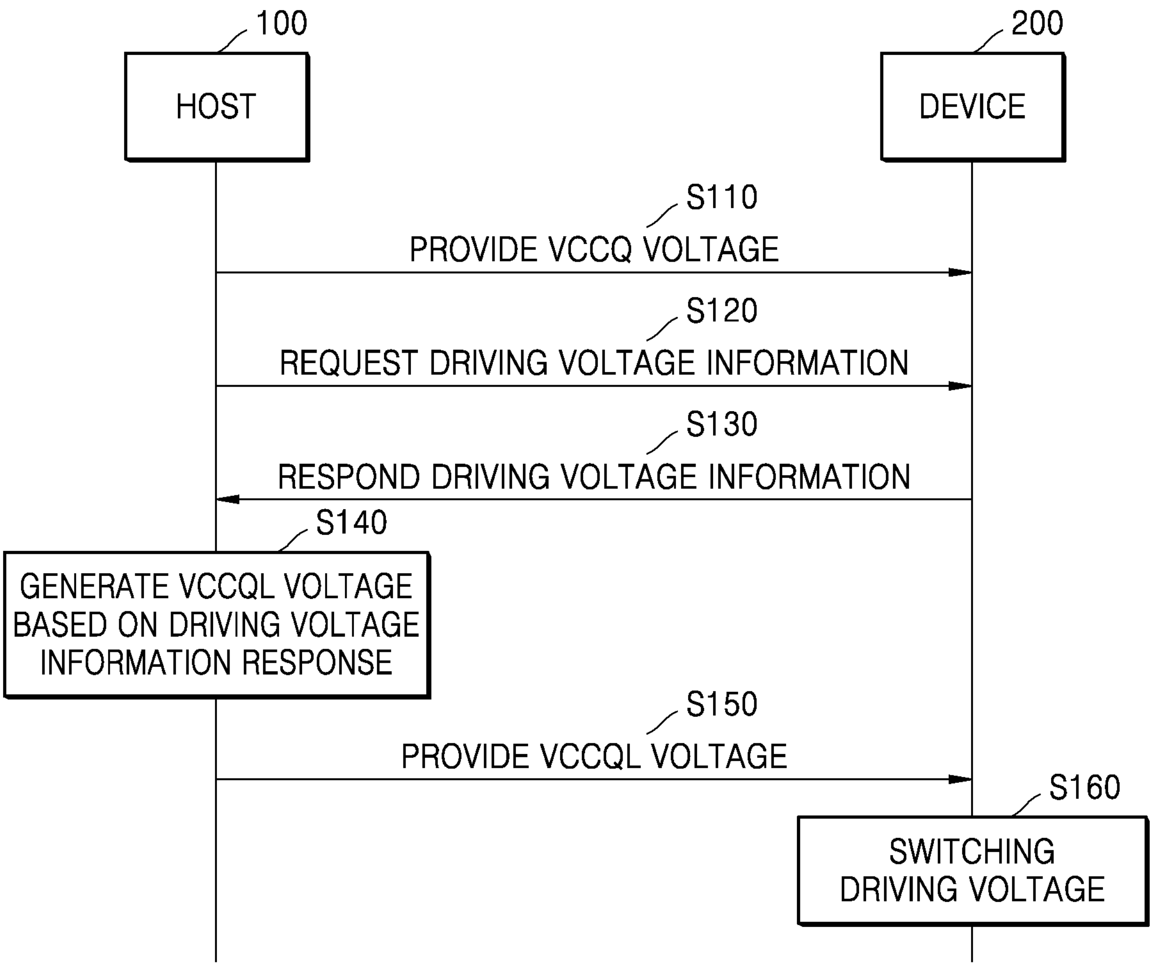
100
HOST
200
DEVICE
S110
PROVIDE VCCQ VOLTAGE
S120
REQUEST DRIVING VOLTAGE INFORMATION
S130
RESPOND DRIVING VOLTAGE INFORMATION
S140
GENERATE VCCQL VOLTAGE BASED ON DRIVING VOLTAGE INFORMATION RESPONSE
S150
PROVIDE VCCQL VOLTAGE
S160
SWITCHING DRIVING VOLTAGE

FIG. 5A

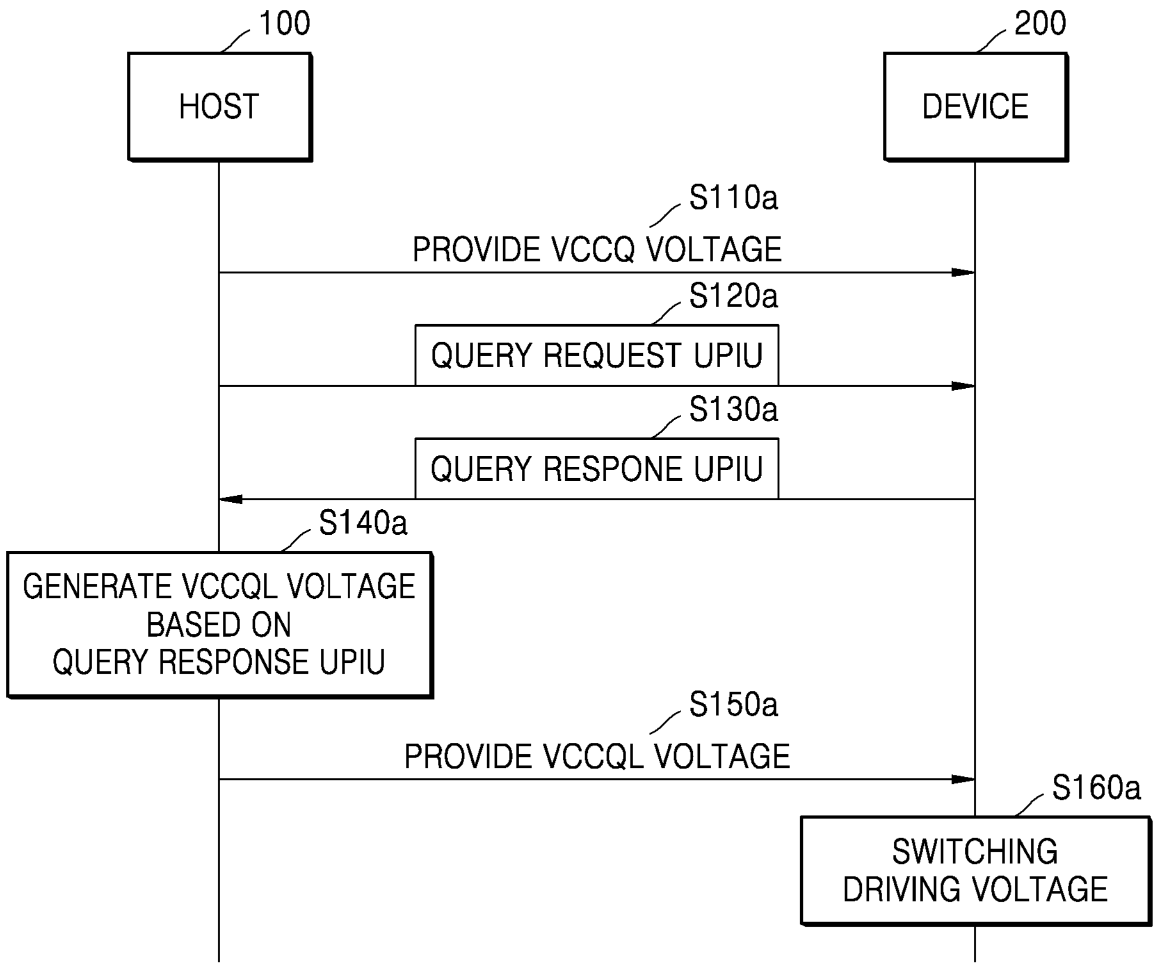
100
HOST
200
DEVICE
S110a
PROVIDE VCCQ VOLTAGE
S120a
QUERY REQUEST UPIU
S130a
QUERY RESPONE UPIU
S140a
GENERATE VCCQL VOLTAGE
BASED ON
QUERY RESPONSE UPIU
S150a
PROVIDE VCCQL VOLTAGE
S160a
SWITCHING
DRIVING VOLTAGE

# FIG. 5B

| | QUERY REQUEST UPIU | | | |
|---|---|---|---|---|
| | 0 xx01 011b | 1 Flags | 2 Reserved | 3 Task Tag |
| | 4 Reserved | 5 Query Function | 6 Reserved | 7 Reserved |
| | 8 Total EHS Length (00h) | 9 Reserved | 10 (MSB) Data Segment Length | 11 (LSB) |
| TSF1 | 12 Transaction Specific Fields | 13 | 14 | 15 |
| TSF1 | 16 Transaction Specific Fields | 17 | 18 | 19 |
| TSF1 | 20 Transaction Specific Fields | 21 | 22 | 23 |
| TSF1 | 24 Transaction Specific Fields | 25 | 26 | 27 |
| | 28 Reserved | 29 | 30 | 31 |
| | Header E2ECRC (omit if HD=0) | | | |
| PL1 | k Data[0] | k + 1 Data[1] | k + 2 Data[2] | k + 3 Data[3] |
| PL1 | . . . | . . . | . . . | . . . |
| PL1 | k + Length−4 Data[Length−4] | k + Length−3 Data[Length−3] | k + Length−2 Data[Length−2] | k + Length−1 Data[Length−1] |
| | Data E2ECRC (omit if DD=0) | | | |

# FIG. 5C

| | QUERY RESPONSE UPIU | | | |
|---|---|---|---|---|
| | 0<br>xx11 0110b | 1<br>Flags | 2<br>Reserved | 3<br>Task Tag |
| | 4<br>Reserved | 5<br>Query Function | 6<br>Query Response | 7<br>Reserved |
| | 8<br>Total EHS Length (00h) | 9<br>Device Information | 10 (MSB)<br>Data Segment Length | 11 (LSB) |
| TSF2 | 12<br>Transaction Specific Fields | 13 | 14 | 15 |
| TSF2 | 16<br>Transaction Specific Fields | 17 | 18 | 19 |
| TSF2 | 20<br>Transaction Specific Fields | 21 | 22 | 23 |
| TSF2 | 24<br>Transaction Specific Fields | 25 | 26 | 27 |
| | 28<br>Reserved | 29 | 30 | 31 |
| | Header E2ECRC (omit if HD=0) | | | |
| PL2 | k<br>Data[0] | k + 1<br>Data[1] | k + 2<br>Data[2] | k + 3<br>Data[3] |
| PL2 | . . . | . . . | . . . | . . . |
| PL2 | k + Length-4<br>Data[Length-4] | k + Length-3<br>Data[Length-3] | k + Length-2<br>Data[Length-2] | k + Length-1<br>Data[Length-1] |
| | Data E2ECRC (omit if DD=0) | | | |

FIG. 5D

| Transaction Specific Fields for READ DESCRIPTOR OPCODE | | | |
|---|---|---|---|
| 12<br>01h | 13<br>DESCRIPTOR IDN | 14<br>INDEX | 15<br>SELECTOR |
| 16<br>Reserved | 17<br>Reserved | 18 (MSB)<br>LENGTH | 19 (LSB) |
| 20<br>Reserved | 21 | 22 | 23 |
| 24<br>Reserved | 25 | 26 | 27 |

FIG. 6A

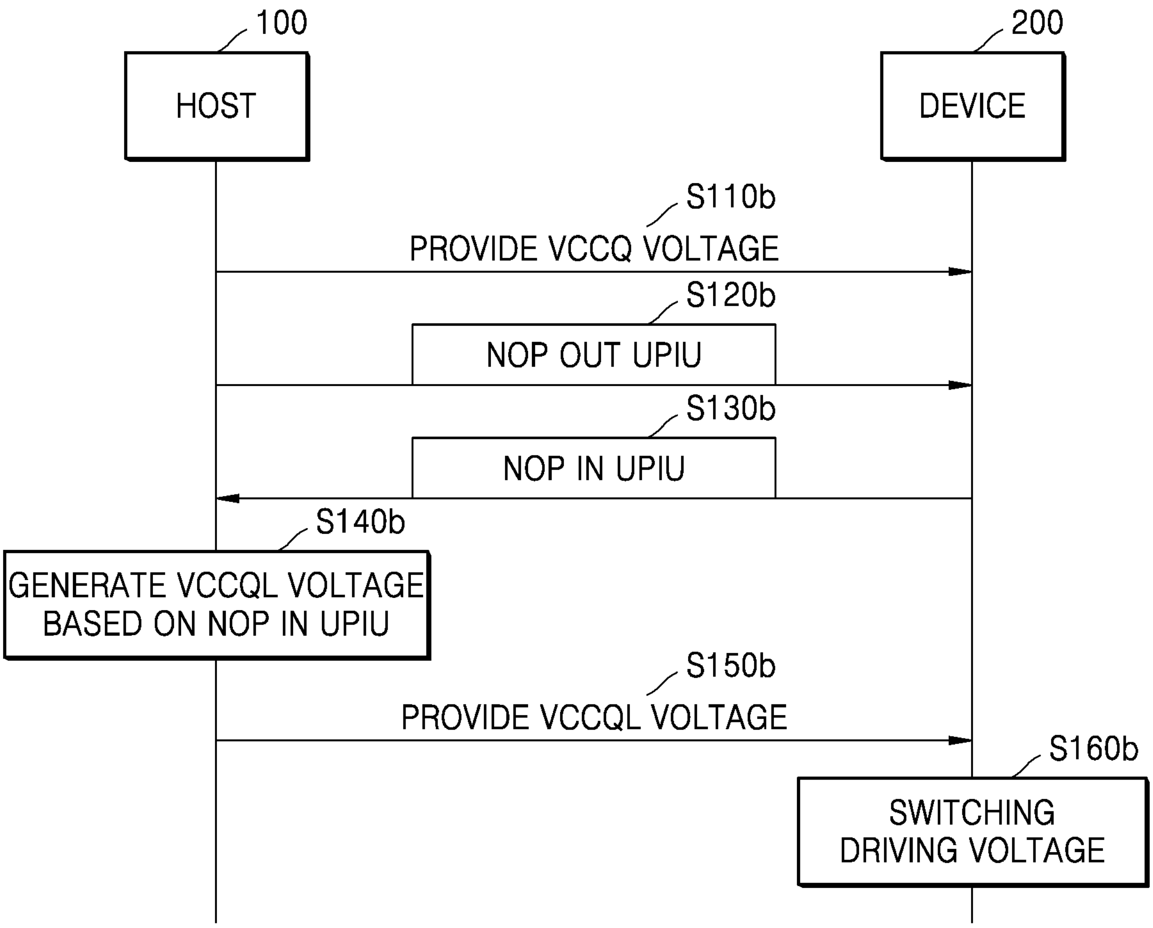
100
HOST
200
DEVICE
S110b
PROVIDE VCCQ VOLTAGE
S120b
NOP OUT UPIU
S130b
NOP IN UPIU
S140b
GENERATE VCCQL VOLTAGE BASED ON NOP IN UPIU
S150b
PROVIDE VCCQL VOLTAGE
S160b
SWITCHING DRIVING VOLTAGE

FIG. 6B

| NOP OUT UPIU | | | |
|---|---|---|---|
| 0<br>xx00 0000b | 1<br>Flags | 2<br>Reserved | 3<br>Task Tag |
| 4<br>Reserved | 5<br>Reserved | 6<br>Reserved | 7<br>Reserved |
| 8<br>Total EHS Length (00h) | 9<br>Reserved | 10 (MSB)<br>Data Segment Length (0000h) | 11 (LSB) |
| 12<br>Reserved | 13 | 14 | 15 |
| 16<br>Reserved | 17 | 18 | 19 |
| 20<br>Reserved | 21 | 22 | 23 |
| 24<br>Reserved | 25 | 26 | 27 |
| 28<br>Reserved | 29 | 30 | 31 |
| 32 (MSB)<br>Header E2ECRC (omit if HD=0) | 33 | 34 | 35 (LSB) |

# FIG. 6C

| NOP IN UPIU | | | |
|---|---|---|---|
| 0 xx10 0000b | 1 Flags | 2 Reserved | 3 Task Tag |
| 4 Reserved | 5 Reserved | 6 Reserved (00h) | 7 Reserved |
| 8 Total EHS Length (00h) | 9 Device Information (00h) | 10 (MSB) Data Segment Length (0000h) | 11 (LSB) |
| 12 Reserved | 13 | 14 | 15 |
| 16 Reserved | 17 | 18 | 19 |
| 20 Reserved | 21 | 22 | 23 |
| 24 Reserved | 25 | 26 | 27 |
| 28 Reserved | 29 | 30 | 31 |
| 32 (MSB) Header E2ECRC (omit if HD=0) | 33 | 34 | 35 (LSB) |

FIG. 7

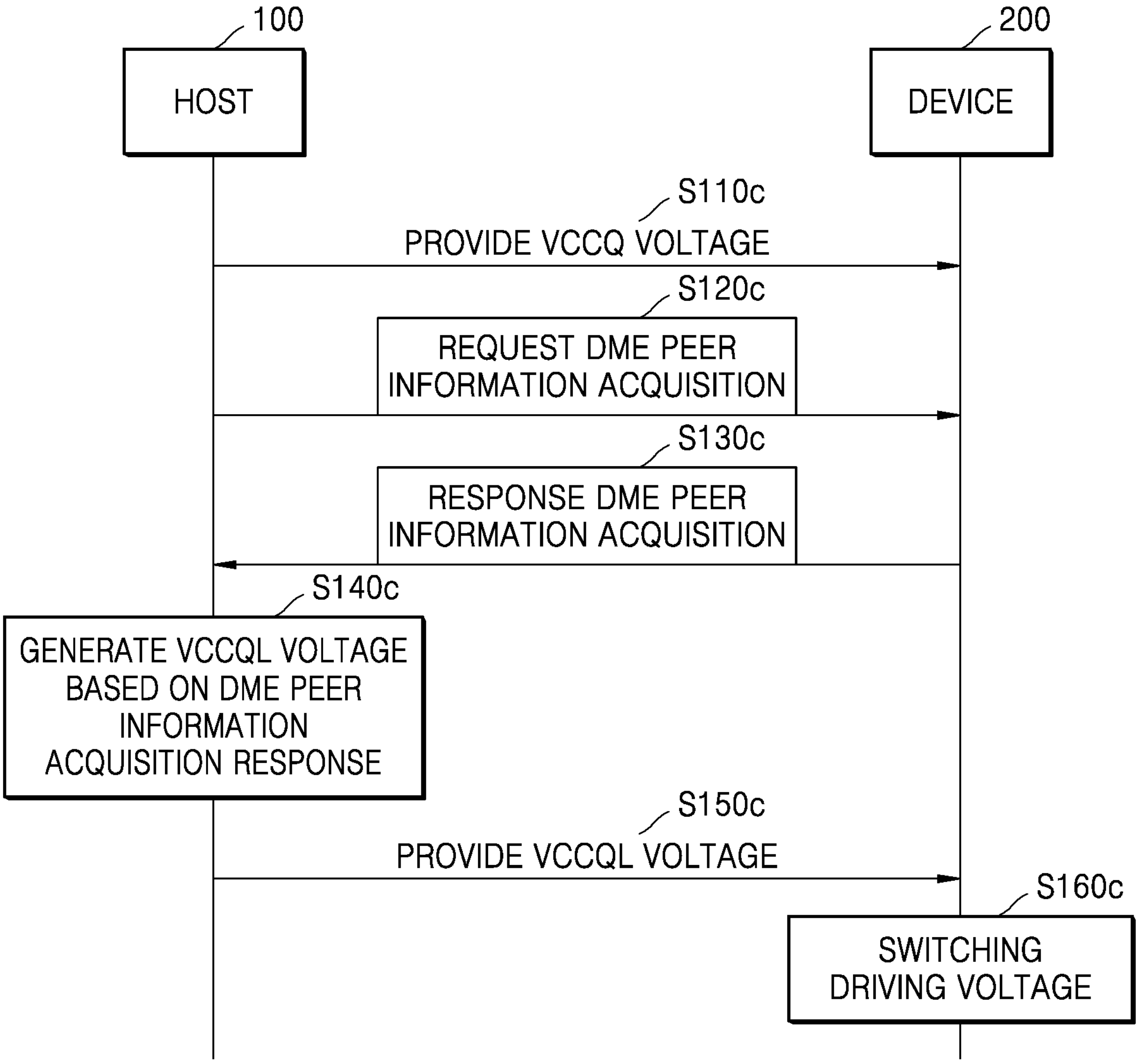
100
HOST
200
DEVICE
S110c
PROVIDE VCCQ VOLTAGE
S120c
REQUEST DME PEER INFORMATION ACQUISITION
S130c
RESPONSE DME PEER INFORMATION ACQUISITION
S140c
GENERATE VCCQL VOLTAGE BASED ON DME PEER INFORMATION ACQUISITION RESPONSE
S150c
PROVIDE VCCQL VOLTAGE
S160c
SWITCHING DRIVING VOLTAGE

FIG. 8

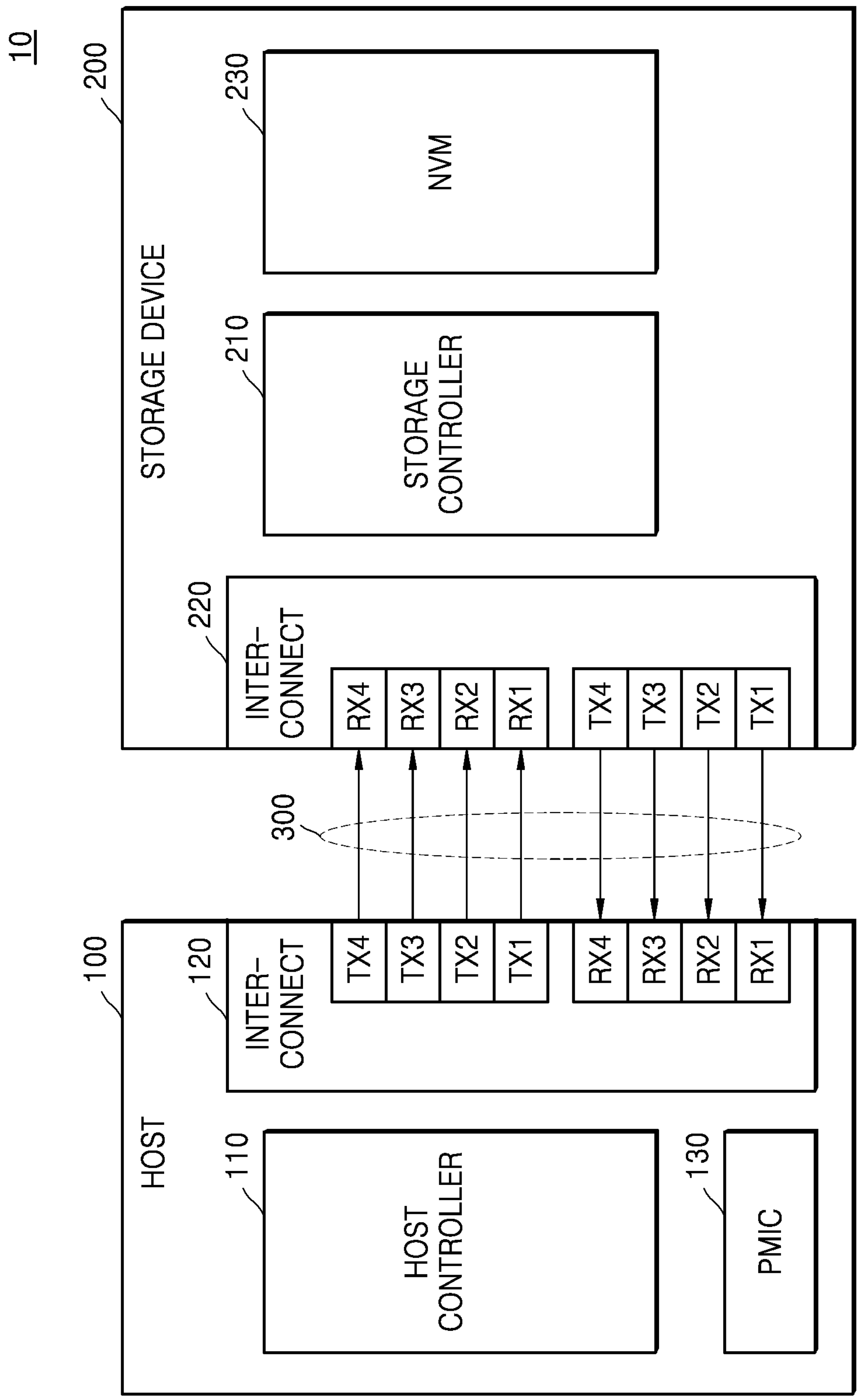
10
200
STORAGE DEVICE
230
NVM
210
STORAGE
CONTROLLER
220
INTER-
CONNECT
RX4
RX3
RX2
RX1
TX4
TX3
TX2
TX1
300
100
HOST
120
INTER-
CONNECT
TX4
TX3
TX2
TX1
RX4
RX3
RX2
RX1
110
HOST
CONTROLLER
130
PMIC

FIG. 9

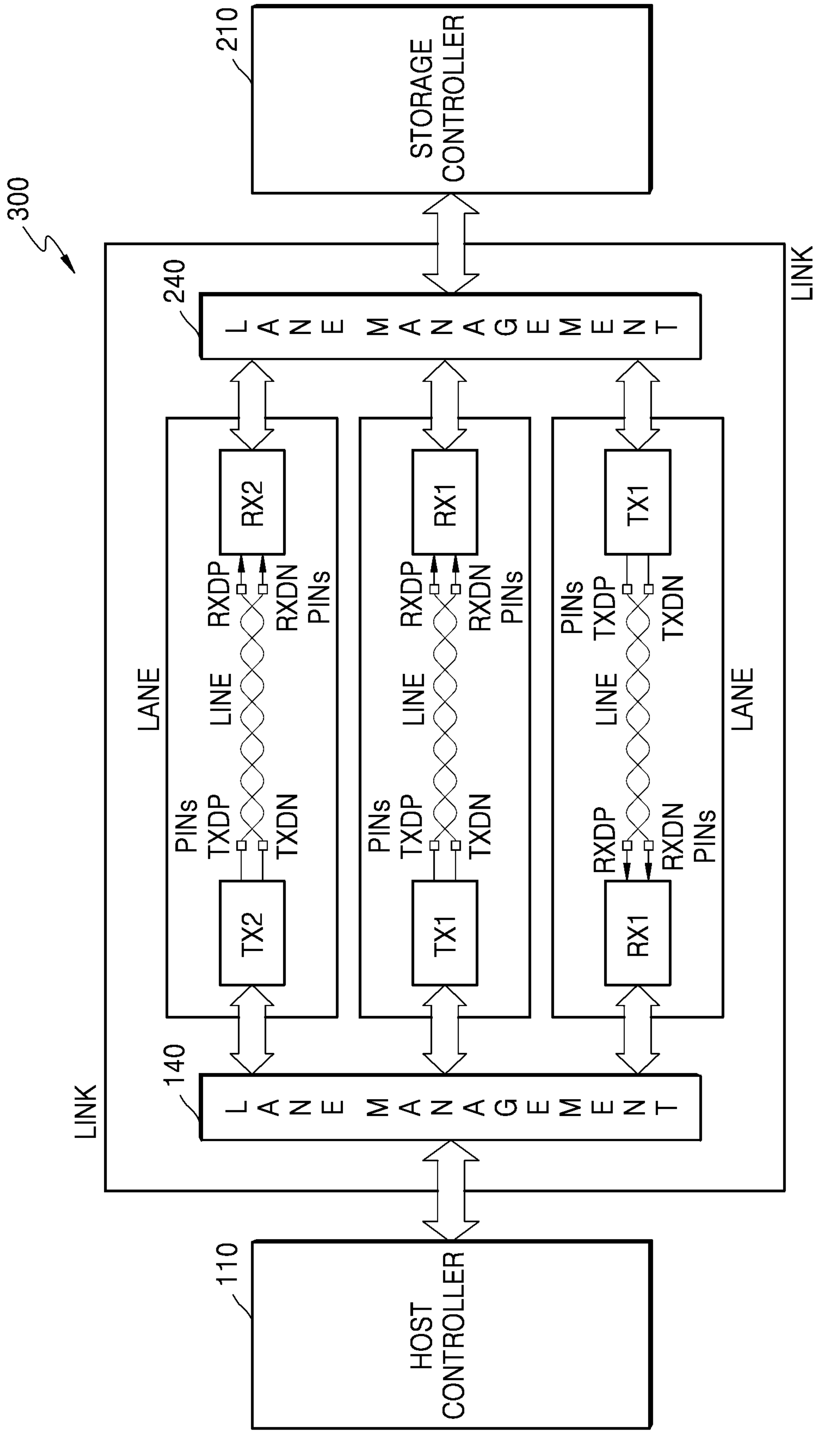

300
110
HOST CONTROLLER
LINK
140
LANE MANAGEMENT
LANE
TX2
PINs
TXDP
TXDN
LINE
RXDP
RXDN
PINs
RX2
TX1
PINs
TXDP
TXDN
LINE
RXDP
RXDN
PINs
RX1
RX1
RXDP
RXDN
PINs
LINE
PINs
TXDP
TXDN
TX1
LANE
240
LANE MANAGEMENT
LINK
210
STORAGE CONTROLLER

FIG. 10

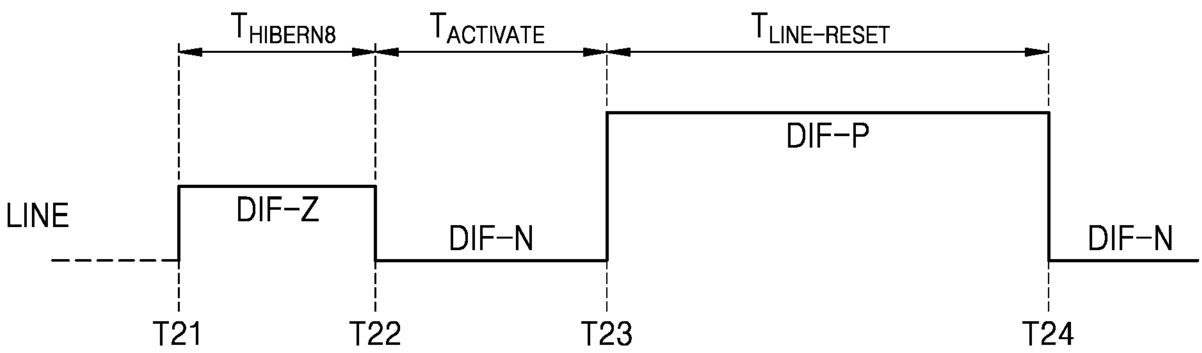
THIBERN8
TACTIVATE
TLINE-RESET
DIF-P
LINE
DIF-Z
DIF-N
DIF-N
T21
T22
T23
T24

# FIG. 11

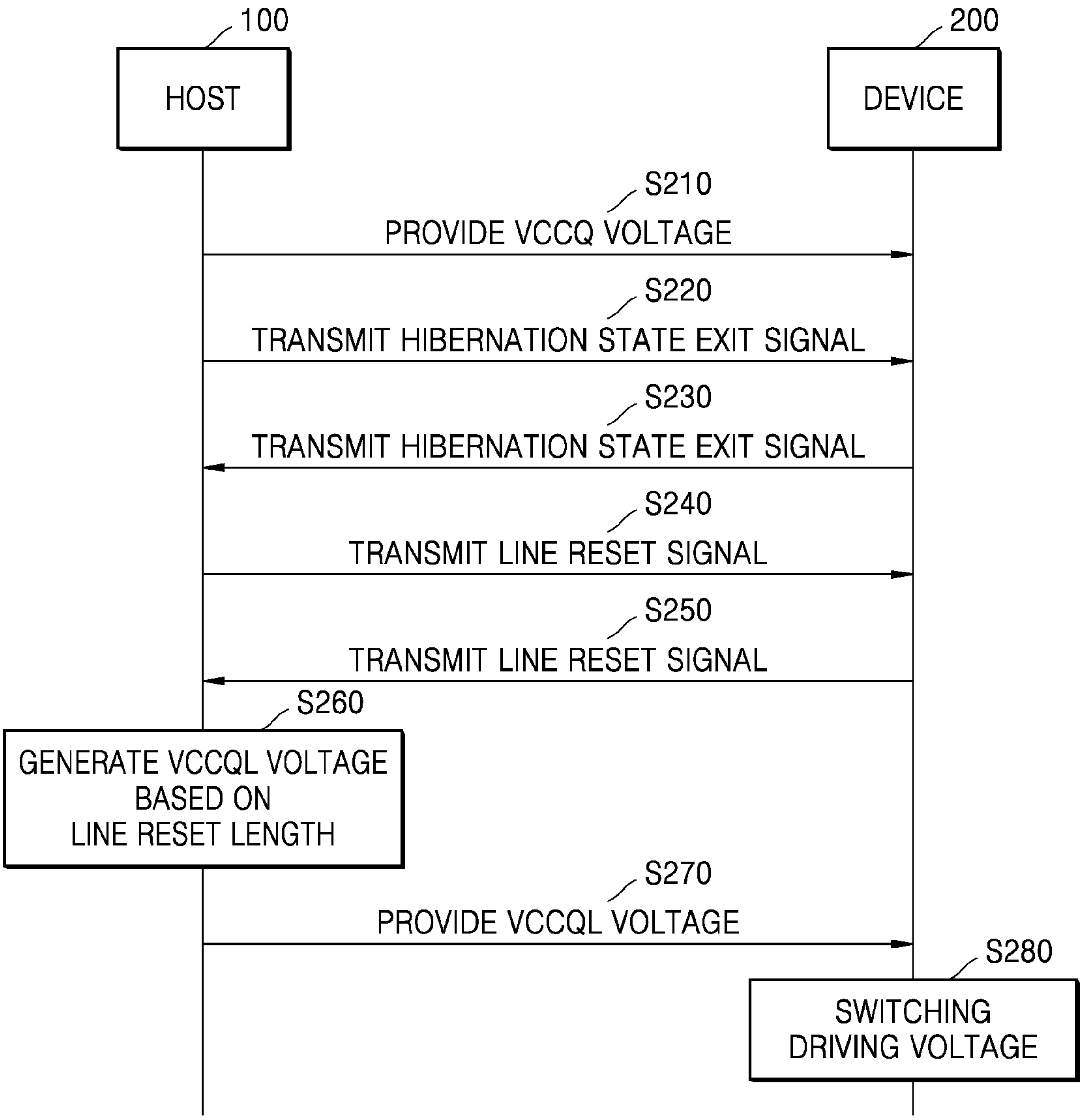
100
HOST
200
DEVICE
S210
PROVIDE VCCQ VOLTAGE
S220
TRANSMIT HIBERNATION STATE EXIT SIGNAL
S230
TRANSMIT HIBERNATION STATE EXIT SIGNAL
S240
TRANSMIT LINE RESET SIGNAL
S250
TRANSMIT LINE RESET SIGNAL
S260
GENERATE VCCQL VOLTAGE BASED ON LINE RESET LENGTH
S270
PROVIDE VCCQL VOLTAGE
S280
SWITCHING DRIVING VOLTAGE

FIG. 12

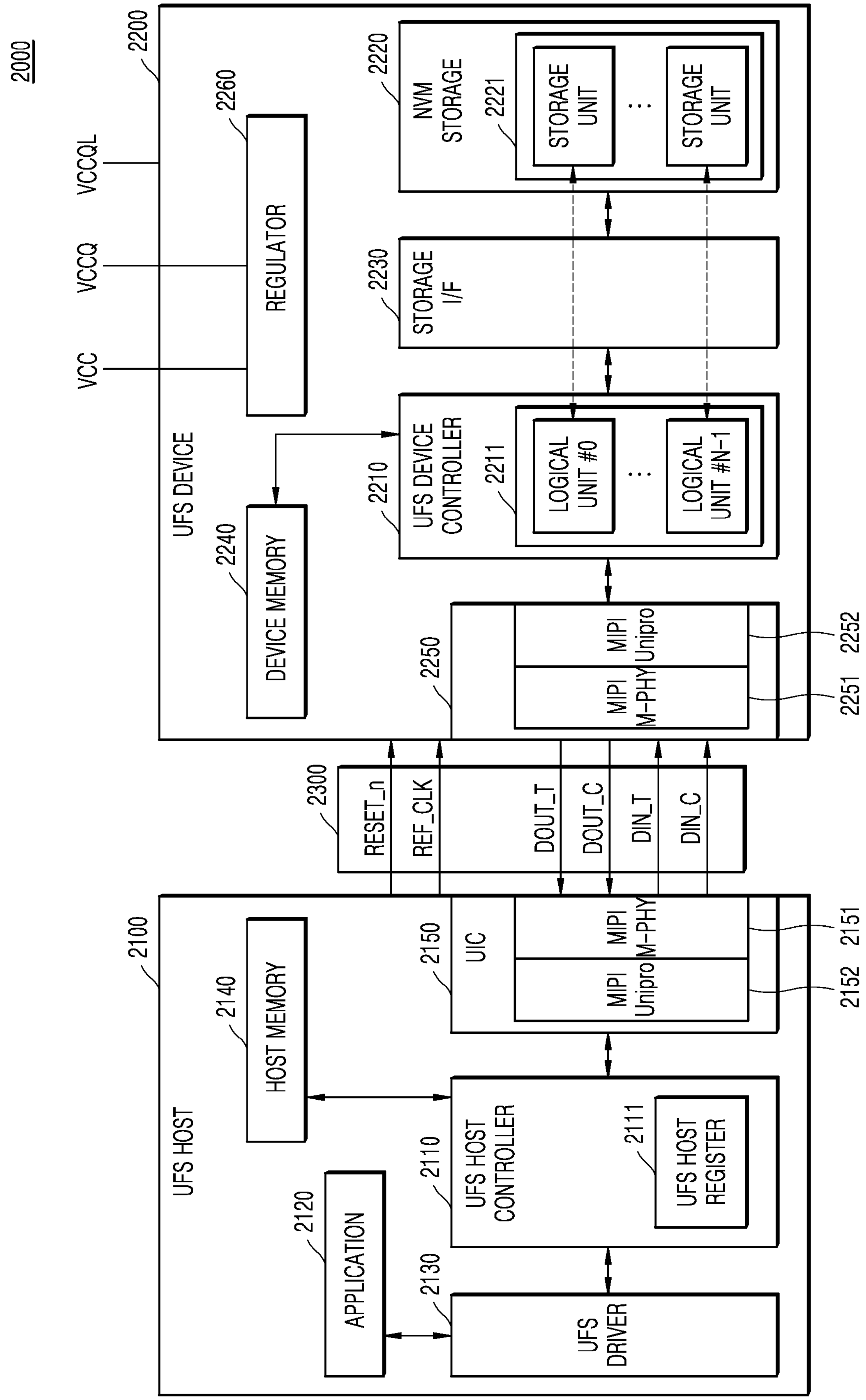
2000
VCC
VCCQ
VCCQL
2200
UFS DEVICE
2260
REGULATOR
2240
DEVICE MEMORY
2220
NVM STORAGE
2221
STORAGE UNIT
...
STORAGE UNIT
2230
STORAGE I/F
2210
UFS DEVICE CONTROLLER
2211
LOGICAL UNIT #0
...
LOGICAL UNIT #N-1
2250
MIPI M-PHY
MIPI Unipro
2251
2252
2300
RESET_n
REF_CLK
DOUT_T
DOUT_C
DIN_T
DIN_C
2100
UFS HOST
2140
HOST MEMORY
2150
UIC
MIPI M-PHY
MIPI Unipro
2151
2152
2110
UFS HOST CONTROLLER
2111
UFS HOST REGISTER
2120
APPLICATION
2130
UFS DRIVER

FIG. 13A

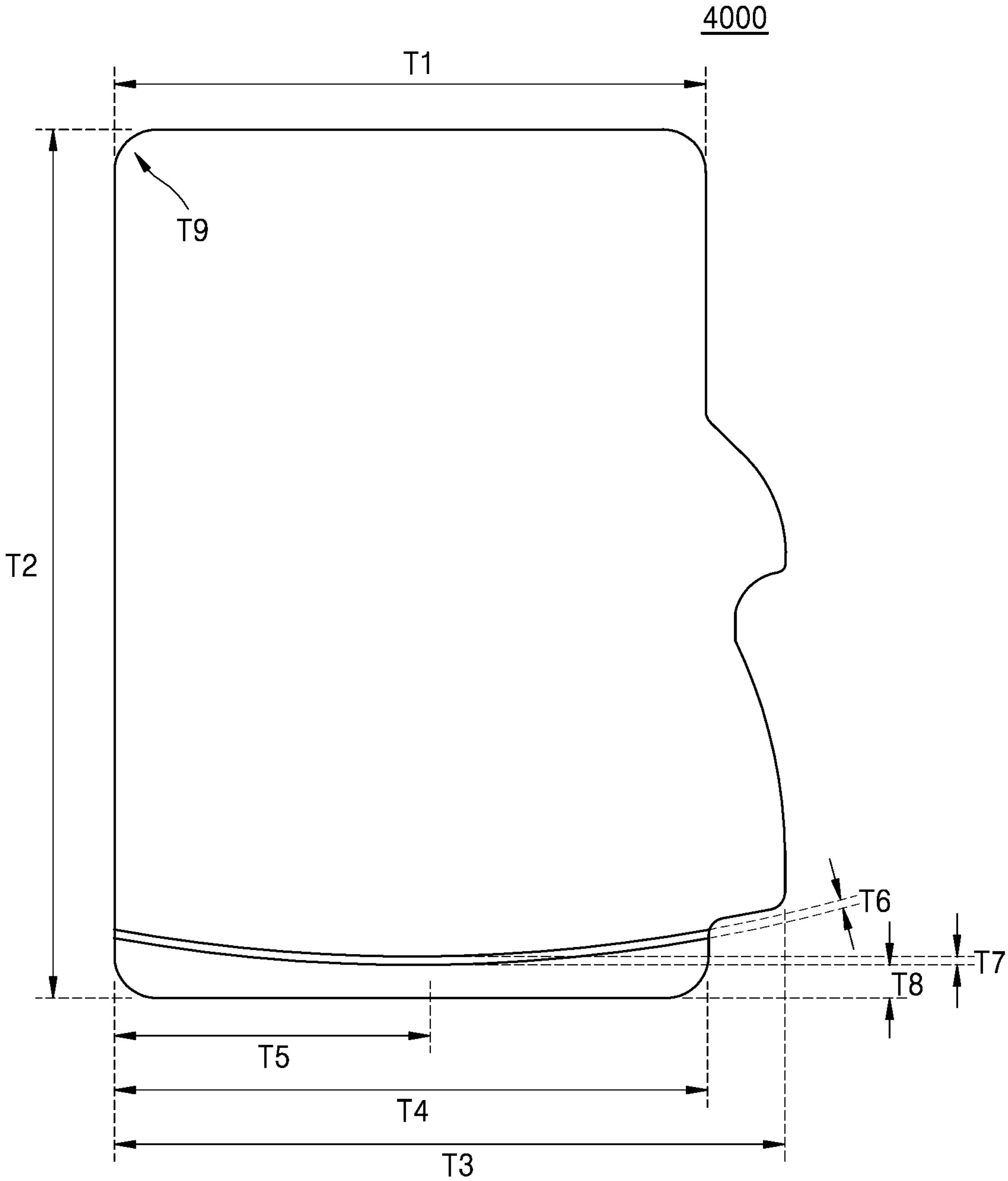

FIG. 13B

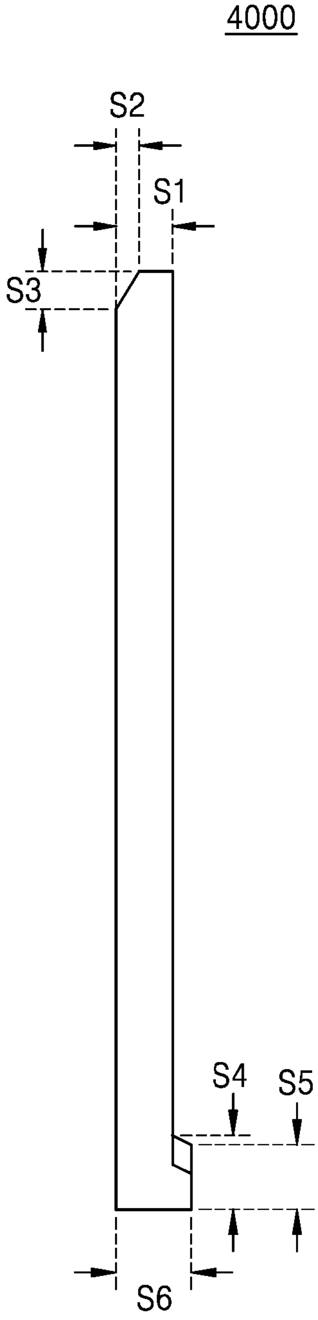

FIG. 13C

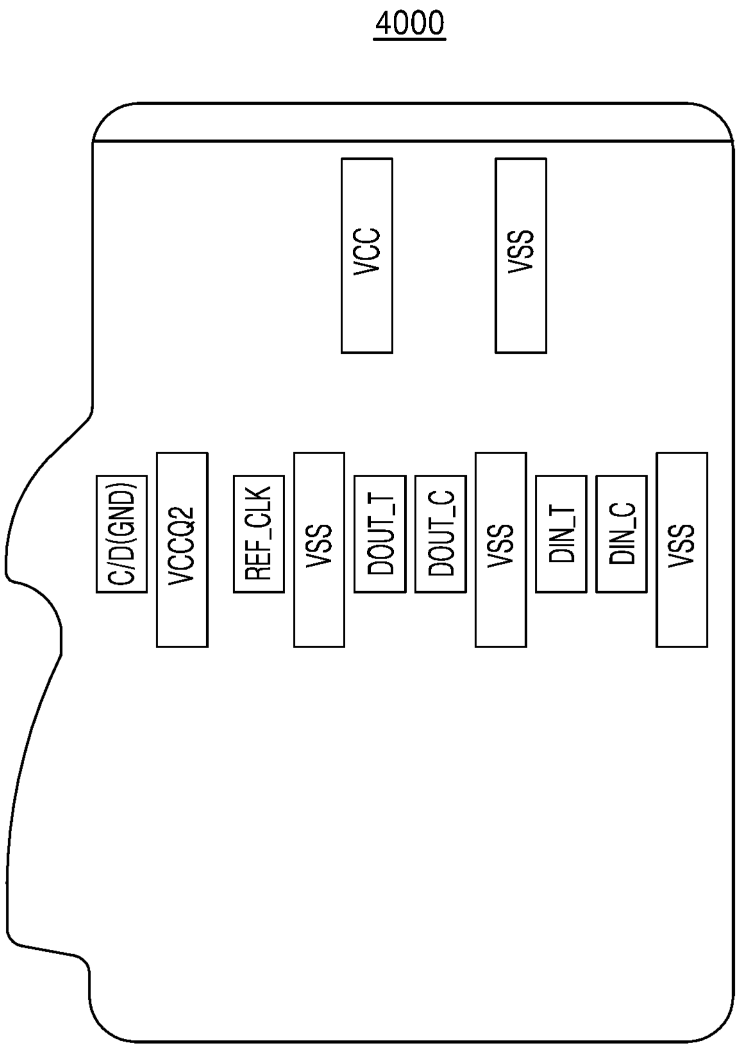
4000
VCC
VSS
C/D(GND)
VCCQ2
REF_CLK
VSS
DOUT_T
DOUT_C
VSS
DIN_T
DIN_C
VSS

Europäisches Patentamt
European Patent Office
Office européen des brevets

# EUROPEAN SEARCH REPORT

Application Number
EP 25 16 2626

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 4 156 191 A1 (SAMSUNG ELECTRONICS CO LTD [KR]) 29 March 2023 (2023-03-29)<br>* abstract *<br>* paragraph [0005] *<br>* paragraph [0018] *<br>* paragraph [0023]; figure 1 *<br>* paragraph [0034]; figure 2 *<br>* paragraph [0039] - paragraph [0040] *<br>* paragraph [0046] *<br>* paragraph [0054] - paragraph [0056] *<br>* paragraph [0070] - paragraph [0082]; figures 5-6 *<br>* paragraph [0117] - paragraph [0121]; figure 11 *<br>----- | 1-15 | INV.<br>G06F1/26<br>G06F3/06<br>G11C5/14<br>G11C16/30 |
| A | US 2017/206974 A1 (KONG JAE-PHIL [KR] ET AL) 20 July 2017 (2017-07-20)<br>* abstract *<br>* paragraph [0122] - paragraph [0126]; figure 15 *<br>----- | 1-15 | |
| | | | TECHNICAL FIELDS SEARCHED (IPC) |
| | | | G06F<br>G11C |

The present search report has been drawn up for all claims

1

| Place of search | Date of completion of the search | Examiner |
|---|---|---|
| The Hague | 23 July 2025 | Reis Rodrigues, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
..........................................................................................
& : member of the same patent family, corresponding document

EPO FORM 1503 03.82 (P04C01)

## ANNEX TO THE EUROPEAN SEARCH REPORT ON EUROPEAN PATENT APPLICATION NO.

EP 25 16 2626

This annex lists the patent family members relating to the patent documents cited in the above-mentioned European search report. The members are as contained in the European Patent Office EDP file on
The European Patent Office is in no way liable for these particulars which are merely given for the purpose of information.

23-07-2025

| Patent document cited in search report | Publication date | Patent family member(s) | Publication date |
|---|---|---|---|
| EP 4156191 A1 | 29-03-2023 | CN 115881196 A | 31-03-2023 |
| | | EP 4156191 A1 | 29-03-2023 |
| | | KR 20230044879 A | 04-04-2023 |
| | | US 2023100119 A1 | 30-03-2023 |
| US 2017206974 A1 | 20-07-2017 | CN 106980467 A | 25-07-2017 |
| | | KR 20170085773 A | 25-07-2017 |
| | | US 2017206974 A1 | 20-07-2017 |

EPO FORM P0459

For more details about this annex : see Official Journal of the European Patent Office, No. 12/82